(19) Europäisches Patentamt
European Patent Office
Office européen des brevets

(11) **EP 2 888 330 B1**

(12) **EUROPÄISCHE PATENTSCHRIFT**

(45) Veröffentlichungstag und Bekanntmachung des Hinweises auf die Patenterteilung:
**21.06.2017 Patentblatt 2017/25**

(21) Anmeldenummer: **13735003.9**

(22) Anmeldetag: **04.07.2013**

(51) Int Cl.:
*C09J 127/16* (2006.01)   *C09K 3/10* (2006.01)
*H05K 5/06* (2006.01)   *H01L 51/52* (2006.01)
*G02F 1/1339* (2006.01)   *C08L 27/16* (2006.01)
*C08L 93/04* (2006.01)

(86) Internationale Anmeldenummer:
**PCT/EP2013/064145**

(87) Internationale Veröffentlichungsnummer:
**WO 2014/029545 (27.02.2014 Gazette 2014/09)**

(54) **HAFTKLEBEMASSE INSBESONDERE ZUR KAPSELUNG EINER ELEKTRONISCHEN ANORDNUNG**

PRESSURE-SENSITIVE ADHESIVE MATERIAL PARTICULARLY FOR ENCASING AN ELECTRONIC ARRANGEMENT

MATÉRIAU ADHÉSIF SENSIBLE À LA PRESSION, EN PARTICULIER POUR ENCAPSULER UN SYSTÈME ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.08.2012 DE 102012215136**
**30.10.2012 DE 102012219877**

(43) Veröffentlichungstag der Anmeldung:
**01.07.2015 Patentblatt 2015/27**

(73) Patentinhaber: **tesa SE**
**22848 Norderstedt (DE)**

(72) Erfinder:
• **KEITE-TELGENBÜSCHER, Klaus**
**22529 Hamburg (DE)**
• **ELLINGER, Jan**
**20257 Hamburg (DE)**

(56) Entgegenhaltungen:
**EP-A1- 1 400 563   EP-A2- 0 132 834**
**EP-A2- 0 399 543   EP-A2- 2 043 147**
**WO-A1-2010/109118   US-A- 4 647 157**
**US-A1- 2004 162 380**

EP 2 888 330 B1

**Beschreibung**

Die vorliegende Erfindung betrifft eine Haftklebemasse insbesondere zur Kapselung einer elektronischen Anordnung.

(Opto-)Elektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren wie Hochdruck, Tiefdruck, Siebdruck, Flachdruck oder auch so genanntes "non impact printing" wie etwa Thermotransferdruck, Tintenstrahldruck oder Digitaldruck. Vielfach werden aber auch Vakuumverfahren wie zum Beispiel Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung, verwendet, wobei die Strukturierung in der Regel durch Masken erfolgt.

Als Beispiele für bereits kommerzielle oder in ihrem Marktpotential interessante (opto-) elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, Elektrolumineszenzlampen, lichtemittierende elektrochemische Zellen (LEECs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und/oder Selen, organische Feldeffekt-Transistoren, organische Schaltelemente, organische optische Verstärker, organische Laserdioden, organische oder anorganische Sensoren oder auch organisch- oder anorganisch basierte RFID-Transponder angeführt.

Als technische Herausforderung für die Realisierung einer ausreichenden Lebensdauer und Funktion von (opto-)elektronischen Anordnungen im Bereich der anorganischen und/oder organischen (Opto-)Elektronik, ganz besonders im Bereich der organischen (Opto-)Elektronik, ist ein Schutz der darin enthaltenen Komponenten vor Permeaten zu sehen. Permeate können eine Vielzahl von niedermolekularen organischen oder anorganischen Verbindungen sein, insbesondere Wasserdampf und Sauerstoff.

Eine Vielzahl von (opto-)elektronischen Anordnungen im Bereich der anorganischen und/oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So kann sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-)Elektronik, insbesondere bei der organischen (Opto-)Elektronik, gibt es besonderen Bedarf für flexible Klebelösungen, die eine Permeationsbarriere für Permeate, wie Sauerstoff und/oder Wasserdampf, darstellen. Daneben gibt es eine Vielzahl von weiteren Anforderungen für derartige (opto-)elektronische Anordnungen. Die flexiblen Klebelösungen sollen daher nicht nur eine gute Haftung zwischen zwei Substraten erzielen, sondern zusätzlich Eigenschaften wie hohe Scherfestigkeit und Schälfestigkeit, chemische Beständigkeit, Alterungsbeständigkeit, hohe Transparenz, einfache Prozessierbarkeit sowie hohe Flexibilität und Biegsamkeit erfüllen.

Spezifische Anforderungen bestehen für Farbstoffsolarzellen, bei denen der Bereich zwischen den beiden Elektroden mit einem Redoxelektrolyten, zum Beispiel einer Lösung aus Iod ($I_2$) und Kaliumiodid, gefüllt ist. Bestandteile des Elektrolyten sind in der Regel auch Ionische Flüssigkeiten und/oder Lösemittel (zum Beispiel Valeronitril, 3-Methoxyvaleronitril). Eine große Hürde für die Farbstoffsolarzellen-Technologie auf ihrem Weg vom Labormaßstab zu großflächigen Anwendungen ist die langzeitstabile Versiegelung des Elektrolyten. Die flexible Klebelösung muss daher neben den oben genannten Eigenschaften auch eine hohe Beständigkeit gegen den Elektrolyten aufweisen.

Ein nach dem Stand der Technik gängiger Ansatz ist deshalb, die elektronische Anordnung zwischen zwei für Wasserdampf und Sauerstoff undurchlässige Substrate zu legen. Anschließend erfolgt dann eine Versiegelung an den Rändern. Für unflexible Aufbauten werden Glas oder Metallsubstrate verwendet, die eine hohe Permeationsbarriere bieten, aber sehr anfällig für mechanische Belastungen sind. Ferner verursachen diese Substrate eine relativ große Dicke der gesamten Anordnung. Im Falle von Metallsubstraten besteht zudem keine Transparenz. Für flexible Anordnungen hingegen kommen Flächensubstrate, wie transparente oder nicht transparente Folien, zum Einsatz, die mehrlagig ausgeführt sein können. Hierbei können sowohl Kombinationen aus verschiedenen Polymeren, als auch anorganische oder organische Schichten verwendet werden. Der Einsatz solcher Flächensubstrate ermöglicht einen flexiblen, äußerst dünnen Aufbau. Dabei sind für die verschiedenen Anwendungen unterschiedlichste Substrate wie zum Beispiel Folien, Gewebe, Vliese und Papiere oder Kombinationen daraus möglich.

Um eine möglichst gute Versiegelung zu erzielen, werden spezielle Barriereklebemassen verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen. Ein geringes Auffließvermögen auf der Anordnung kann durch unvollständige Benetzung der Oberfläche der Anordnung und durch zurückbleibende Poren die Barrierewirkung an der Grenzfläche verringern, da ein seitlicher Eintritt von Sauerstoff und Wasserdampf unabhängig von den Eigenschaften der Klebmasse ermöglicht wird. Nur wenn der Kontakt zwischen Masse und Substrat durchgängig ist, sind die Masseeigenschaften der bestimmende Faktor für die Barrierewirkung der Klebemasse.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff beziehungsweise Wasserdampf durch einen Film unter spezifischen Bedingungen von Temperatur und Partialdruck sowie gegebenenfalls weiterer Messbedingungen wie relativer Luftfeuchtigkeit an. Je geringer die Werte für OTR oder WVTR sind, desto besser ist das jeweilige Material zur Kapselung geeignet. Die Angabe der Permeation basiert dabei nicht allein auf den Werten für WVTR oder OTR, sondern beinhaltet immer auch eine Angabe zur mittleren Weglänge der Permeation wie zum Beispiel die Dicke des Materials oder eine Normalisierung auf eine bestimmte Durchtrittsweglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und ein definiertes Permeat unter stationären Bedingungen bei bestimmter Permeationsweglänge, Partialdruck und Temperatur. Die Permeabilität P ist das Produkt aus Diffusions-Term D und Löslichkeits-Term S:

$$P = D * S$$

Der Löslichkeitsterm S beschreibt vorliegend die Affinität der Barriereklebemasse zum Permeat. Im Fall von Wasserdampf wird beispielsweise ein geringer Wert für S von hydrophoben Materialen erreicht. Der Diffusionsterm D ist ein Maß für die Beweglichkeit des Permeats im Barrierematerial und ist direkt abhängig von Eigenschaften wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ein geringer Löslichkeitsterm S ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeitsterm), weisen aber durch ihre frei drehbare Si-O-Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeitsterm S und Diffusionsterm D notwendig.

Ansätze, um die Barrierewirkung einer Klebemasse zu erhöhen, müssen die beiden Parameter D und S insbesondere im Hinblick auf den Einfluss auf die Durchlässigkeit von Wasserdampf und Sauerstoff berücksichtigen. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Hierfür werden bisher vor allem Flüssigklebstoffe und Adhäsive auf Basis von Epoxiden verwendet (WO98/21287 A1; US 4,051,195 A; US 4,552,604 A). Diese haben durch eine starke Vernetzung einen geringen Diffusionsterm D. Ihr Haupteinsatzgebiet sind Randverklebungen starrer Anordnungen, aber auch mäßig flexibler Anordnungen. Eine Aushärtung erfolgt thermisch oder mittels UV-Strahlung. Eine vollflächige Verklebung ist aufgrund des durch die Aushärtung auftretenden Schrumpfes kaum möglich, da es beim Aushärten zu Spannungen zwischen Kleber und Substrat kommt, die wiederum zur Delaminierung führen können.

Der Einsatz dieser flüssigen Klebstoffe birgt eine Reihe von Nachteilen. So können niedermolekulare Bestandteile (VOC - volatile organic compound) die empfindlichen elektronischen Strukturen der Anordnung schädigen und den Umgang in der Produktion erschweren. Der Klebstoff muss aufwändig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess und auch durch den anschließend erforderlichen Laminationsschritt kann durch die geringe Viskosität das Erreichen einer definierten Schichtdicke und Verklebungsbreite in engen Grenzen erschwert sein.

Des Weiteren weisen solche hochvernetzten Klebstoffe nach dem Aushärten nur noch eine geringe Flexibilität auf. Der Einsatz von thermisch-vernetzenden Systemen wird im niedrigen Temperaturbereich oder bei 2-Komponenten-Systemen durch die Topfzeit begrenzt, also die Verarbeitungszeit bis eine Vergelung stattgefunden hat. Im hohen Temperaturbereich und insbesondere bei langen Reaktionszeiten begrenzen wiederum die empfindlichen (opto-)elektronischen Strukturen die Verwendbarkeit derartiger Systeme. Die maximal anwendbaren Temperaturen bei (opto-)elektronischen Strukturen liegen oft bei 60 °C, da bereits ab dieser Temperatur eine Vorschädigung eintreten kann. Insbesondere flexible Anordnungen, die organische Elektronik enthalten und mit transparenten Polymerfolien oder Verbunden aus Polymerfolien und anorganischen Schichten gekapselt sind, setzen hier enge Grenzen. Dies gilt auch für Laminierschritte unter großem Druck. Um eine verbesserte Haltbarkeit zu erreichen, ist hier ein Verzicht auf einen temperaturbelastenden Schritt und eine Laminierung unter geringerem Druck von Vorteil.

Alternativ zu den thermisch härtbaren Flüssigklebstoffen werden mittlerweile vielfach auch strahlenhärtende Klebstoffe eingesetzt (US 2004/0225025 A1). Die Verwendung von strahlenhärtenden Klebstoffen vermeidet eine lange andauernde Wärmebelastung der elektronischen Anordnung.

Insbesondere wenn die (opto-)elektronischen Anordnungen flexibel sein sollen, ist es wichtig, dass der verwendete Kleber nicht zu starr und spröde ist. Daher sind besonders Haftklebemassen und hitzeaktiviert verklebbare Klebefolien geeignet für eine solche Verklebung. Um auf den Untergrund gut aufzufließen, aber gleichzeitig eine hohe Verklebungsfestigkeit zu erzielen, sollten die Klebemassen zunächst möglichst weich sein, dann aber vernetzt werden können. Als Vernetzungsmechanismen lassen sich je nach chemischer Basis der Klebemasse Temperaturhärtungen und/oder Strahlenhärtungen durchführen. Während die Temperaturhärtung recht langsam ist, können Strahlungshärtungen innerhalb weniger Sekunden initiiert werden. Daher sind Strahlenhärtungen, insbesondere die UV-Härtung, insbesondere bei kontinuierlichen Herstellverfahren bevorzugt.

Die DE 10 2008 060 113 A1 beschreibt ein Verfahren zur Kapselung einer elektronischen Anordnung gegen Permeate, bei dem eine Haftklebemasse auf Basis von Butylenblockcopolymeren, insbesondere Isobutylenblockcopolymeren, genutzt wird, und die Verwendung einer solchen Klebemasse in einem Kapselungsverfahren. In Kombination mit den Elastomeren werden bestimmte Harze, charakterisiert durch DACP- und MMAP-Werte bevorzugt. Die Klebemasse ist zudem bevorzugt transparent und kann UVblockende Eigenschaften zeigen. Als Barriereeigenschaften weist die Klebemasse bevorzugt ein WVTR von < 40 g/m$^2$*d und ein OTR von < 5000 g/m$^2$*d bar auf. In dem Verfahren kann die Haftklebemasse während und/oder nach der Applikation erwärmt werden. Die Haftklebemasse kann vernetzt werden zum Beispiel strahlenchemisch. Es werden Substanzklassen vorgeschlagen, über die eine solche Vernetzung vorteilhaft ausgeführt werden kann. Jedoch werden keine konkreten Beispiele gegeben, die zu besonders geringer Volumen- und Grenzflächenpermeation bei hoher Transparenz und Flexibilität führen.

Die EP 1 518 912 A1 lehrt eine Klebemasse zur Kapselung eines Elektrolumineszenzelements, das eine photokationisch härtbare Verbindung und einen photokationischen Initiator enthält. Die Härtung erfolgt nach Lichtstimulation als Dunkelreaktion. Der Kleber ist bevorzugt auf Epoxy-Basis. Es können aliphatische Hydroxide und Polyether als covernetzende Komponenten zugesetzt sein. Zudem kann ein Klebharz enthalten sein, um Adhäsion und Kohäsion einzustellen. Darunter kann auch Polyisobutylen sein. Es werden keine speziellen Angaben zur Verträglichkeit der einzelnen Bestandteile gemacht und auch keine Angaben zu den Molmassen der Polymere. Das Dokument EP 0 399 543 A2 offenbart die Verwendung einer Zusammensetzung, die ein fluorhaltiges thermoplastisches Elastomer und ein fluorhaltiges flüssiges Elastomer umfasst, als druckempfindlichen Kleber.

Das Dokument US 4,647,157 A beschreibt ein viskoses Dichtungsmittel, das ein fluorelastomeres Terpolymer enthält. Das Dokument betrifft ein Fluorelastomer-Terpolymer, das die Versiegelung von Flüssigkristallmaterial bezweckt, das zwischen Platten lokalisiert ist, d.h. die Versiegelung einer hochempfindlichen optoelektronischen Anordnung. Eine Mischung aus fluorhaltigen flüssigen Elastomeren und fluorhaltigen thermoplastischen Elastomeren wird nicht erwähnt. Aufgabe der Erfindung ist es, eine Haftklebemasse zur Verfügung zu stellen, die den schädlichen Einfluss von Sauerstoff und Wasserdampf auf empfindliche Funktionsschichten wie zum Beispiel im Bereich von organischen Photozellen für Solarmodule oder im Bereich von organischen Licht emittierenden Dioden (OLEDs) durch eine gute Barrierewirkung gegenüber den schädlichen Substanzen unterbinden kann, die langzeitbeständig gegenüber äußeren Einflüssen wie Witterung oder UV-Licht ist, die inert gegenüber dem (opto-)elektronischen Aufbau ist, die verschiedene Bauteile der Funktionselemente miteinander verbinden kann, die gut handhabbar in Verklebungsprozessen ist, die eine flexible und saubere Verarbeitung erlaubt und die trotzdem beim Hersteller einfach zu verarbeiten ist. Insbesondere ist es eine Aufgabe der Erfindung, eine Haftklebemasse zur Verkapselung von Farbstoffsolarzellen zur Verfügung zu stellen, die inert ist gegen die in diesen Zellen verwendeten Elektrolyte.

Gelöst wird diese Aufgabe durch eine Haftklebemasse, wie sie im Hauptanspruch näher gekennzeichnet ist. In den Unteransprüchen sind vorteilhafte Ausführungsformen der

Erfindung beschrieben. Teil der Erfindung ist eine Variante der erfindungsgemäßen Haftklebemasse. Des Weiteren ist die Verwendung der erfindungsgemäßen Klebemassen vom erfinderischen Gedanken umfasst.

Demgemäß betrifft die Erfindung eine Haftklebemasse zur Kapselung einer elektronischen Anordnung gegen Permeate, die zu mindestens 70 Gew.-%, vorzugsweise mindestens 90 Gew.-% (jeweils bezogen auf die Gesamtzusammensetzung der Haftklebemasse) eine Mischung aus zumindest einem fluorhaltigen thermoplastischen Elastomer und zumindest einem fluorhaltigen flüssigen Elastomer umfasst, wobei das Massenverhältnis des fluorhaltigen flüssigen Elastomers zu dem fluorhaltigen thermoplastischen Elastomer zwischen 5:95 bis 55:45 liegt, bevorzugt zwischen 15:75 und 50:50 und besonders bevorzugt zwischen 25:75 und 40:60.

Die erfindungsgemäße Klebemasse ist als Haftklebemasse ausgeführt. Im Folgenden werden die Begriffe Klebemasse und Haftklebemasse daher in der Regel synonym verwendet.

Als Haftklebemassen werden Klebemassen bezeichnet, die bereits unter relativ schwachem Andruck eine dauerhafte Verbindung mit dem Haftgrund erlauben und nach Gebrauch im Wesentlichen rückstandsfrei vom Haftgrund wieder abgelöst werden können. Haftklebemassen wirken bei Raumtemperatur permanent haftklebrig, weisen also eine hinreichend geringe Viskosität und eine hohe Anfass¬klebrigkeit auf, so dass sie die Oberfläche des jeweiligen Klebegrunds bereits bei geringem Andruck be¬netzen. Die Verklebbarkeit der Klebemassen beruht auf ihren adhäsiven Eigenschaften und die Wiederablösbarkeit auf ihren kohäsiven Eigenschaften.

Darunter fallen insbesondere Massen, die haftklebende Eigenschaften entsprechend dem "Handbook of Pressure Sensitive Adhesive Technology" von Donatas Satas (Satas & Associates, Warwick 1999) besitzen, insbesondere solche, die das Dahlquist-Kriterium erfüllen.

Das oder die fluorhaltigen thermoplastischen Elastomer(e) werden vorzugsweise gewählt aus der Gruppe bestehend aus

- einem fluorhaltigen Elastomer mit mindestens einem weichen Segment, bestehend aus einem Terpolymer aus Vinylidenfluorid/Hexafluorpropylen/Tetrafluorethylen oder Vinylidenfluorid/Chlortrifluorethylen/Tetrafluorethylen, und mindestens einem harten Segment, bestehend aus einem Copolymer aus Tetrafluorethylen/Ethylen oder Chlortrifluorethylen/Ethylen oder Polyvinylidenfluorid,
- einem fluorhaltigen Elastomer mit mindestens einem weichen Segment aus einem Copolymer aus Tetrafluorethylen/Propylen und mindestens einem harten Segment aus einem Copolymer aus Tetrafluorethylen/Ethylen und/oder
- einem fluorhaltigen Elastomer mit mindestens einem weichen Segment aus einem amorphen kautschukartigen Copolymer aus Tetrafluorethylen/Perfluoralkylvinylether und mindestens einem harten Segment aus einem Copolymer aus Tetrafluorethylen/Perfluoralkylvinylether, worin der Gehalt an Perfluoralkylvinylether geringer ist als im weichen Segment.

Spezielle Beispiele des fluorhaltigen thermoplastischen Elastomers sind

- ein Elastomer, das mindestens ein weiches Segment aus einem Terpolymer aus Vinylidenfluorid/Hexafluorpropylen/Tetrafluorethylen oder Vinylidenfluorid/Chlortrifluorethylen/Tetrafluorethylen und mindestens ein hartes Segment aus einem Copolymer aus Tetrafluorethylen/Ethylen oder Chlortrifluorethylen/Ethylen oder Polyvinylidenfluorid umfasst,
- ein Elastomer, das mindestens ein weiches Segment aus einem Copolymer aus Tetrafluorethylen/Propylen und mindestens ein hartes Segment aus einem Copolymer aus Tetrafluorethylen/Ethylen umfasst und/oder
- ein Elastomer, das mindestens ein weiches Segment aus einem amorphen kautschukartigen Copolymer aus Tetrafluorethylen/Perfluoralkylvinylether und mindestens ein hartes Segment aus einem Copolymer aus Tetrafluorethylen/Perfluoralkylvinylether umfasst, worin der Gehalt von Perfluoralkylvinylether geringer ist als im weichen Segment.

Diese fluorhaltigen thermoplastischen Elastomere sind in der JP 53 086 786 A und in der US 4,158,678 A offenbart.

Das fluorhaltige thermoplastische Elastomer wird vorzugsweise nach Verfahren hergestellt, die in der JP 53 003 495 A und in der US 4,158,678 A beschrieben sind.

Das fluorhaltige thermoplastische Elastomer hat den Vorteil, transparent zu sein.

Mit der Transparenz beziehungsweise dem Transmissionsgrad - bisweilen auch nur kurz als Transmission bezeichnet -, der in der Regel in % angegeben wird, ist das Verhältnis der auf der Rückseite eines mit Licht durchstrahlten Körpers ankommenden Lichtleistung zu der auf der Vorderseite eintreffenden Lichtleistung gemeint. Die Transmission wird beschnitten durch Reflektion und Absorption.

Es gilt also: Transmissionsgrad = (1 - Reflektionsgrad - Absorptionsgrad). Vorzugsweise die thermoplastischen Elastomere eine Transmission von größer 75 % auf, insbesondere eine Transmission größer 90 %, jeweils bei einer Wellenlänge von 350 bis 1150 nm.

In einer bevorzugten Ausführungsform der vorliegenden Erfindung werden das fluorhaltige thermoplastische Elastomer und das fluorhaltige flüssige Elastomer so kombiniert, dass die das thermoplastische fluorhaltige Elastomer verträglich mit dem fluorhaltigen flüssigen Elastomer ist, also das erstere im letzteren frei aufquillt oder gelöst wird. Die Monomerzusammensetzung des Weichsegments des thermoplastischen Elastomers oder die Monomerzusammensetzung des fluorhalten Co- oder Terpolymers wird ähnlich der Monomerzusammensetzung des flüssigen Elastomers gewählt, um eine Phasenseparation bei allen bevorzugten Masseverhältnissen der Komponenten zu vermeiden. Anderenfalls kommt es zu einer Migration der flüssigen Komponente und einer Eigenschaftsveränderung der Haftklebemasse

Eine bevorzugte Kombination der Elastomere ist eine Kombination eines fluorhaltigen flüssigen Elastomers aus Vinylidenfluorid, Hexafluorpropylen und Tetrafluorethylen und eines fluorhaltigen thermoplastischen Elastomers, das ein weiches Segment aus demselben Terpolymer wie das flüssige Elastomer umfasst. Eine weitere bevorzugte Kombination der Elastomeren ist eine Kombination eines fluorhaltigen flüssigen Elastomers, das ein Tetrafluorethylen/Propylencopolymer oder ein Tetrafluorethylen/Perfluorpropylvinylethercopolymer ist und eines fluorhaltigen thermoplastischen Elastomeren mit einem weichen Segment aus demselben Copolymer wie das Flüssigelastomer.

Beispiele für das harte Segment des fluorhaltigen thermoplastischen Elastomeren sind ein kristallines Copolymer-Segment, das Tetrafluorethylen und Ethylen umfasst, ein Polyvinylidenfluorid-Segment, ein kristallines Copolymer-Segment aus Tetrafluorethylen und Perfluorpropylvinylether.

Die erfindungsgemäße Zusammensetzung kann durch Mischen des fluorhaltigen thermoplastischen Elastomeren und des fluorhaltigen flüssigen Elastomeren mit einer Kautschukwalze, einer Kalanderwalze oder einem Kneter bei einer Temperatur von Raumtemperatur bis etwa 200 °C unter Erhalt einer homogenen Verbindung hergestellt werden. Erforderlichenfalls kann ein Lösungsmittel, das mit der Zusammensetzung kompatibel ist, verwendet werden. Die Elastomerzusammensetzung kann in der Form einer Lösung verwendet werden, um ihre Verarbeitung leicht zu machen, obwohl sie auch ohne Lösungsmittel bei hoher Temperatur verarbeitet werden kann. Alternativ kann die Klebezusammensetzung der vorliegenden Erfindung durch Mischen wässriger Dispersionen der Elastomere und Entfernung von Wasser hergestellt werden.

Bevorzugt werden das fluorhaltige (thermoplastische) Elastomer und das flüssige fluorhaltige Elastomer in einem geeigneten Lösemittel gelöst. Dies können beispielsweise niedere Ketone und Ester sein.

Das in der vorliegenden Erfindung verwendete fluorhaltige flüssige Elastomer kann durch ein Verfahren zur Herabsetzung des Molekulargewichts des Elastomers hergestellt werden, das offenbart ist in der JP 56 057 811 A und in der US 4,361,678 A.

Vorzugsweise hat das fluorhaltige Elastomer stabilisierte molekulare Enden und geht kaum chemische Reaktionen ein, so dass eine Alterung der Klebeeigenschaft verhindert wird. Bevorzugte Beispiele von fluorhaltigen flüssigen Elastomeren sind Elastomere auf Grundlage von Vinylidenfluorid/Hexafluorpropylen, von Vinylidenfluorid/Hexafluorpropylen/Tetrafluorethylen, von Tetrafluorethylen/Propylen, von Hexafluorpropylen/Ethylen, Fluorsilicon-Elastomere und Fluor-substituierte Phosphazen-Elastomere. Das flüssige Elastomer hat ein Molekulargewichtszahlenmittel $M_z$ von 500 bis 20.000, vorzugsweise 500 bis 10.000. Sie können unabhängig oder als Mischung verwendet werden.

Um die Klebkraft oder Eigenschaften der Klebezusammensetzung zu verbessern, kann eine funktionelle Gruppe wie -OH oder -COOH in die Polymerketten oder an die Polymerkettenenden eingeführt werden. Eine solche Gruppe kann in die Polymer-Ketten eingeführt werden, indem man eine Verbindung der Formel: $CF_2=CFCH_2CH_2OH$ oder $CF_2=CFCF_2COOH$ statistisch copolymerisiert.

Um die Adhäsion der Haftklebemasse und damit die Wärmescherfestigkeit zu verbessern, kann die Haftklebemasse vernetzt werden. Dies kann über eine aminische Vernetzung, Vernetzung mit einem Bisphenol (wie zum Beispiel Bisphenol AF) oder über Peroxide erfolgen. Derartige Vernetzungsprozesse sind dem Fachmann bekannt und werden insbesondere für die Herstellung von hochvernetzten Fluorkautschuken eingesetzt. Details zur Vernetzung von Fluorpolymeren können zum Beispiel dem "Fluoroelastomer Handbook: The Definite Users Guide and Databook, Alber L. Moore, 2005 William Andrew Publishing/Plastics Design Library" entnommen werden.

Bevorzugt wird für die erfindungsgemäße Verwendung die aminische Vernetzung eingesetzt - hierbei werden besonders mindestens difunktionelle primäre und/oder sekundäre Amine verwendet. Beispielhaft genannt für primäre und/oder sekundäre Amine seien hier die Epikure-Serie von Momentive (etwa Epikure 925, Triethylene tetramin, 3,6-Diazaoctan-1,8-diamine), Jeffamine von Huntsman (etwa Jeffamine SD 2001, sekundäres Polyetheramin) oder Baxxodur von BASF. Bevorzugt werden aliphatische Amine eingesetzt, um eine gute Alterungsstabilität zu erreichen.

Bevorzugt werden in Kombination mit den genannten primären und/oder sekundären Aminen starke organische Basen (bevorzugt tertiäre Amine, wie Amidine oder Guanidine) wie zum Beispiel DBU (1,8-Diazabicyclo[5.4.0]undec-7-en), TBD (1,5,7-Triazabicyclo(4.4.0)dec-5-ene), DBN (1,5-Diazabicyclo[4.3.0]non-5-ene) oder weiter, wie etwa in der Jeffcat Serie von Huntsman erhältlich eingesetzt, da dies eine beschleunigte Vernetzungsreaktion bei im Vergleich zu üblichen Verfahren niedrigen Temperaturen ermöglicht

Bevorzugt werden von der starken Base maximal bis zu 1,0 Gew.-% bezogen auf den Fluorelastomeranteil eingesetzt, um eine ausreichend lange Topfzeit zu erreichen. Bevorzugt werden 0,005 bis 0,5 Gew.-% und besonders bevorzugt 0,01 bis 0,2 Gew.-% eingesetzt.

Um eine ausreichende Vernetzungsdichte und damit Kohäsion des Haftklebers zu erreichen, werden von dem primären und/oder sekundären Amin zwischen 0,1 Gew.-% und 10 Gew.-%, bevorzugt 0,25 Gew.-% bis 5 Gew.-% und besonders bevorzugt 0,5 Gew.-% bis 3 Gew.-% eingesetzt.

zusätzlich wird optional ein Säurefänger, wie zum Beispiel ein nanoskaliges Metalloxid wie MgO oder CaO, eingesetzt um entstehendes HF abzufangen. Nanoskalige Metalloxide ermöglichen transparente Haftkleber, und es können aufgrund der hohen Oberfläche geringere Mengen eingesetzt werden.

Standardvernetzungen nur mit, zum Beispiel Hexamethylendiamin bei der Aminvernetzung oder Vernetzungen

über ein Bisphenol (zum Beispiel Bisphenol A oder Bisphenol AF) mit anorganischen Basen, wie Calciumhydroxid benötigen Vernetzungstemperaturen von über 170 °C für 15 bis 30 Minuten. Eine Vernetzung über Peroxide und Crosslinker wie TAIC (Triallylisocyanurat) ist ebenfalls möglich, jedoch sind in der Polymerkette eingebaute Cure-Side Monomere zwingend notwendig. Falls diese nicht vorhanden sind, ist keine vollständige Vernetzung möglich. Eine weitere Möglichkeit der Vernetzung ist die Elektronenstrahlhärtung.

Füllstoffe können vorteilhaft in den erfindungsgemäßen Haftklebemassen eingesetzt werden. Bevorzugt werden als Füllstoffe der Klebmasse nanoskalige und/oder transparente Füllstoffe verwendet. Als nanoskalig wird ein Füllstoff vorliegend bezeichnet, wenn er in mindestens einer Dimension eine maximale Ausdehnung von etwa 100 nm, bevorzugt von etwa 10 nm, aufweist. Besonders bevorzugt werden solche in der Masse transparente Füllstoffe mit plättchenförmiger Kristallitstruktur und einem hohen Aspektverhältnis bei homogener Verteilung verwendet. Die Füllstoffe mit plättchenartiger Kristallitstruktur und Aspektverhältnissen weit über 100 haben in der Regel nur eine Dicke von einigen nm, die Länge beziehungsweise die Breite der Kristallite kann aber bis zu einigen $\mu$m betragen. Derartige Füllstoffe werden ebenfalls als Nanopartikel bezeichnet. Die partikuläre Ausgestaltung der Füllstoffe mit kleinen Abmessungen ist zudem besonders vorteilhaft für eine transparente Auslegung der Haftklebemasse. Beispielhaft genannt seinen hier etwa nanoskalige Füllstoffe auf Basis von $SiO_2$, $BaSO_4$ oder MgO.

Durch den Aufbau labyrinthartiger Strukturen mithilfe der zuvor beschriebenen Füllstoffe in der Klebstoffmatrix wird der Diffusionsweg von zum Beispiel Sauerstoff und Wasserdampf derartig verlängert, dass ihre Permeation durch die Klebstoffschicht hindurch vermindert wird. Zur besseren Dispergierbarkeit dieser Füllstoffe in der Bindemittelmatrix können diese Füllstoffe mit organischen Verbindungen oberflächlich modifiziert werden. Der Einsatz derartiger Füllstoffe an sich ist beispielsweise aus der US 2007/0135552 A1 sowie der WO 02/026908 A1 bekannt.

In einer weiteren vorteilhaften Ausführung der vorliegenden Erfindung werden auch Füllstoffe, die mit Sauerstoff und/oder Wasserdampf in besonderer Weise wechselwirken können, eingesetzt. In die (opto-)elektronische Anordnung eindringender Sauerstoff oder Wasserdampf wird dann an diesen Füllstoffen chemisch oder physikalisch gebunden. Diese Füllstoffe werden auch als "getter", "scavenger", "desiccants" oder "absorber" bezeichnet. Solche Füllstoffe umfassen beispielhaft, aber nicht einschränkend oxidierbare Metalle, Halide, Salze, Silicate, Oxide, Hydroxide, Sulfate, Sulfite, Carbonate von Metallen und Übergangsmetallen, Perchlorate und aktivierten Kohlenstoff, einschließlich seiner Modifikationen. Beispiele sind Cobaltchlorid, Calciumchlorid, Calciumbromid, Lithiumchlorid, Zinkchlorid, Zinkbromid, Siliciumdioxid (Silica Gel), Aluminiumoxid (aktiviertes Aluminium), Calciumsulfat, Kupfersulfat, Natriumdithionit, Natriumcarbonat, Magnesiumcarbonat, Titandioxid, Bentonit, Montmorillonit, Diatomenerde, Zeolithe und Oxide von (Erd)Alkalimetallen, wie Bariumoxid, Calciumoxid, Eisenoxid und Magesiumoxid oder auch Kohlenstoffnanoröhrchen. Des Weiteren können auch organische Absorber wie beispielsweise Polyolefin-Copolymere, Polyamid-Copolymere, PET-Copolyester oder weitere auf Hybridpolymeren basierte Absorber, die meist in Kombination mit Katalysatoren wie beispielsweise Cobalt verwendet werden eingesetzt werden. Weitere organische Absorber sind etwa schwach vernetzte Polyacrylsäure, Ascorbate, Glucose, Gallussäure oder ungesättigte Fette und Öle.

Um eine möglichst gute Wirksamkeit der Füllstoffe hinsichtlich der Barrierewirkung zu erzielen, sollte ihr Anteil nicht zu gering sein. Der Anteil beträgt vorzugsweise mindestens 3 Gew.-%, weiter bevorzugt mindestens 7 Gew.-% und ganz bevorzugt mindestens 10 Gew.-%. Typischerweise wird ein möglichst hoher Anteil von Füllstoffen eingesetzt, ohne dabei die Klebkräfte der Klebemasse zu stark herabzusetzen oder weitere Eigenschaften zu beeinträchtigen. Die erfindungsgemäße Mischung kann einen Füllstoff enthalten, und zwar zu maximal 30 Gew.-% (bezogen auf die Gesamtzusammensetzung der Klebemasse). Bevorzugt übersteigt der Anteil der Füllstoffe nicht 20 Gew.-%, vorzugsweise nicht 15 Gew.-% (bezogen auf die Gesamtzusammensetzung der Klebemasse).

Des Weiteren ist eine möglichst feine Verteilung und möglichst hohe Oberfläche der Füllstoffe vorteilhaft. Dies ermöglicht einen höheren Wirkungsgrad und eine höhere Beladungskapazität und wird insbesondere mit nanoskaligen Füllstoffen erreicht.

Die Füllstoffe sind nicht zwingend, die Klebemasse funktioniert auch ohne, dass diese einzeln oder in beliebiger Kombination zugesetzt sind.

Die erfindungsgemäße Klebemasse enthält zumindest eine Sorte eines zumindest teilhydrierten Klebharzes, vorteilhaft solche, die mit dem Copolymer beziehungsweise, sofern ein aus Hart- und Weichblöcken aufgebautes Copolymer eingesetzt wird, hauptsächlich mit dem Weichblock verträglich sind (Weichharze).

Es ist vorteilhaft, wenn dieses Klebharz eine Klebharzerweichungstemperatur von größer 25 °C aufweist. Es ist darüber hinaus vorteilhaft, wenn ergänzend zumindest eine Sorte Klebharz mit einer Klebharzerweichungstemperatur von kleiner 20 °C eingesetzt wird. Hierüber kann, falls erforderlich, zum einen das klebtechnische Verhalten, zum anderen aber auch das Auffließverhalten auf dem Verklebungsuntergrund feineingestellt werden.

Als Harze können in der Haftklebemasse zum Beispiel partiell oder vollständig hydrierte Harze auf Basis von Kolophonium und Kolophoniumderivaten, insbesondere Glycerinester von vollhydriertem Kolophonium, hydrierte Polymerisate des Dicyclopentadiens, partiell, selektiv oder vollständig hydrierte Kohlenwasserstoffharze auf Basis von $C_5$-, $C_5/C_9$- oder $C_9$-Monomerströmen, Polyterpenharze auf Basis von $\alpha$-Pinen und/oder ß-Pinen und/oder $\delta$-Limonen, hydrierte Polymerisate von bevorzugt reinen $C_8$- und $C_9$-Aromaten. Vorgenannte Klebharze können sowohl allein als auch im Gemisch eingesetzt werden.

Dabei können sowohl bei Raumtemperatur feste als auch flüssige Harze zum Einsatz kommen. Um eine hohe Alterungs- und UV-Stabilität zu gewährleisten, sind hydrierte Harze mit einem Hydrierungsgrad von mindestens 90 %, vorzugsweise von mindestens 95 % bevorzugt.

Des Weiteren sind unpolare Harze mit einem DACP-Wert (diacetone alcohol cloud point) oberhalb von 30 °C und einem MMAP-Wert (mixed methylcylohexane aniline point) von größer 50 °C, insbesondere mit einem DACP-Wert oberhalb von 37 °C und einem MMAP-Wert größer 60 °C bevorzugt. Der DACP-Wert und der MMAP-Wert geben jeweils die Löslichkeit in einem bestimmten Lösemittel an. Durch die Auswahl dieser Bereiche wird eine besonders hohe Permeationsbarriere, insbesondere gegen Wasserdampf, erreicht. Überraschend verträglich sind polare Harze mit einem DACP-Wert von weniger als 20 °C und einem MMAP-Wert von weniger als 0 °C. Mit solchen Harzen kann die Klebkraft deutlich gesteigert werden.

Der Klebemasse können übliche Zuschlagstoffe wie Alterungsschutzmittel (Antiozonantien, Antioxidantien, Lichtschutzmittel usw.) zugesetzt sein.

Als Additive zur Klebemasse werden typischerweise genutzt:

- Plastifizierungsmittel wie zum Beispiel Weichmacheröle oder niedermolekulare flüssige Polymere wie zum Beispiel niedermolekulare Polybutene
- primäre Antioxidantien wie zum Beispiel sterisch gehinderte Phenole
- sekundäre Antioxidantien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Netzadditive
- Haftvermittler
- Endblockverstärkerharze und/oder
- gegebenenfalls weitere Polymere von bevorzugt elastomerer Natur; entsprechend nutzbare Elastomere beinhalten unter anderem solche auf Basis reiner Kohlenwasserstoffe, zum Beispiel ungesättigte Polydiene wie natürliches oder synthetisch erzeugtes Polyisopren oder Polybutadien, chemisch im wesentlichen gesättigte Elastomere wie zum Beispiel gesättigte Ethylen-Propylen-Copolymere, $\alpha$-Olefincopolymere, Polyisobutylen, Butylkautschuk, Ethylen-Propylenkautschuk, sowie chemisch funktionalisierte Kohlenwasserstoffe wie zum Beispiel halogenhaltige, acrylathaltige, allyl- oder vinyletherhaltige Polyolefine

Die Zuschlagstoffe sind ebenfalls nicht zwingend, die Klebemasse funktioniert auch, ohne dass diese einzeln oder in beliebiger Kombination zugesetzt sind.

Weiter bevorzugt kommt eine Klebemasse zum Einsatz, die in bestimmten Ausführungen im sichtbaren Licht des Spektrums (Wellenlängenbereich von etwa 400 nm bis 800 nm) transparent ist. Die gewünschte Transparenz lässt sich insbesondere durch die Verwendung farbloser Klebharze erzielen. Eine derartige Haftklebemasse eignet sich somit auch besonders gut für einen vollflächigen Einsatz über einer (opto-)elektronischen Struktur. Eine vollflächige Verklebung bietet, bei einer etwa mittigen Anordnung der elektronischen Struktur gegenüber einer Randversiegelung den Vorteil, dass der Permeat durch die gesamte Fläche diffundieren müsste, bevor er die Struktur erreicht. Der Permeationsweg ist somit deutlich erhöht. Die in dieser Ausführungsform verlängerten Permeationswege im Vergleich zur Randversiegelung etwa durch Flüssigklebstoffe wirken sich positiv auf die Gesamtbarriere aus, da der Permeationsweg umgekehrt proportional zur Durchlässigkeit ist.

"Transparenz" bedeutet dabei eine mittlere Transmission der Klebemasse im sichtbaren Bereich des Lichts von mindestens 75 %, bevorzugt höher als 90 %, wobei sich diese Betrachtung auf unkorrigierte Transmission, also ohne Grenzflächenreflexionsverluste herauszurechnen, bezieht.

Vorzugsweise zeigt die Klebemasse einen Haze kleiner 5,0 %, bevorzugt kleiner 2,5 %.

Die erfindungsgemäßen fluorhaltigen thermoplastischen Elastomere und die erfindungsgemäßen fluorhaltigen flüssigen Elastomere sind beispielsweise kommerziell erhältlich unter dem Namen Dai-El von Daikin (zum Beispiel G-Series oder T500-Series und G-101), Viton von Dupont (zum Beispiel Viton A-100 und A-200), Dyneon von 3M (zum Beispiel FC 2211, FC2230 oder FE5832X) oder Tecnoflon von Solvay Plastics (zum Beispiel N215 oder N535).

In bevorzugten Ausführungsformen liegt der Fluorgehalt in den fluorhaltigen Elastomeren (thermoplastisch und/oder flüssig) bei mindestens 55 Gew.-%, bevorzugt mindestens 60 Gew.-% und besonders bevorzugt bei mindestens 65 Gew.-% vor.

Bevorzugt werden thermoplastische Typen eingesetzt, da diese vollständig transparent sind.

Besonders vorteilhaft lässt sich die erfindungsgemäße Klebemasse in einem ein- oder doppelseitig klebenden Klebeband verwenden. Diese Darreichungsart erlaubt eine besonders einfache und gleichmäßige Applikation der Klebemasse.

Der allgemeine Ausdruck "Klebeband" umfasst dabei ein Trägermaterial, welches ein- oder beidseitig mit einer (Haft)klebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto-)elektronischen Anordnung), Mehrschichtanordnungen und dergleichen. Dabei sind für verschiedene Anwendungen unterschiedlichste Träger wie zum Beispiel Folien, Gewebe, Vliese und Papiere mit den Klebmassen kombinierbar. Des Weiteren umfasst der Ausdruck "Klebeband" auch so genannte "Transferklebebänder", das heißt ein Klebeband ohne Träger. Bei einem Transferklebeband ist die Klebemasse vielmehr vor der Applikation zwischen flexiblen Linern aufgebracht, die mit einer Trennschicht versehen sind und/oder anti-adhäsive Eigenschaften aufweisen. Zur Applikation wird regelmäßig zunächst ein Liner entfernt, die Klebemasse appliziert und dann der zweite Liner entfernt. Die Klebemasse kann so direkt zur Verbindung zweier Oberflächen in (opto-)elektronischen Anordnungen verwendet werden.

Es sind aber auch Klebebänder möglich, bei denen nicht mit zwei Linern sondern mit einem einzigen doppelseitig trennend ausgerüstet Liner gearbeitet wird. Die Klebebandbahn ist dann an ihrer Oberseite mit der einen Seite eines doppelseitig trennend ausgerüsteten Liners abgedeckt, ihre Unterseite mit der Rückseite des doppelseitig trennend ausgerüsteten Liners, insbesondere einer benachbarten Windung auf einem Ballen oder einer Rolle.

Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien/Folienverbunde können aus allen gängigen zur Folienherstellung verwendeten Kunststoffen bestehen, beispielhaft aber nicht einschränkend erwähnt seien:

Polyethylen, Polypropylen - insbesondere das durch mono-oder biaxiale Streckung erzeugte orientierte Polypropylen (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Ethylentetrafluorethylen (ETFE), Polyacrylnitril (PAN), Polycarbonat (PC), Polyamid (PA), Polyethersulfon (PES) oder Polyimid (PI).

Der Träger kann zudem mit organischen oder anorganischen Beschichtungen oder Schichten kombiniert sein. Dies kann durch übliche Verfahren wie zum Beispiel Lackieren, Drucken, Bedampfen, Sputtern, Co-Extrusion oder Lamination geschehen. Beispielhaft, aber nicht einschränkend erwähnt seien hier etwa Oxide oder Nitride des Siliziums und des Aluminiums, Indium-Zinn-Oxid (ITO) oder Sol-Gel-Beschichtungen.

Besonders bevorzugt sind diese Folien/Folienverbunde, insbesondere die Polymerfolien mit einer Permeationsbarriere für Sauerstoff und Wasserdampf versehen, wobei die Permeationsbarriere die Anforderungen für den Verpackungsbereich übertrifft (WVTR < $10^{-1}$ g/(m$^2$d); OTR < $10^{-1}$ cm$^3$/(m$^2$d bar)).

Zudem können die Folien/Folienverbunde in bevorzugter Ausgestaltung transparent ausgebildet sein, damit auch der Gesamtaufbau eines derartigen Klebeartikels transparent ausgebildet ist. "Transparenz" bedeutet auch hier eine mittlere Transmission im sichtbaren Bereich des Lichts von mindestens 75 %, bevorzugt höher als 90 %.

Bei doppelseitig (selbst)klebenden Klebebändern können als obere und untere Schicht erfindungsgemäße Klebemassen gleicher oder verschiedener Art und/oder gleicher oder verschiedener Schichtdicke zur Anwendung kommen. Der Träger kann dabei auf einer oder beiden Seiten dem Stand der Technik entsprechend vorbehandelt sein, so dass beispielsweise eine Verbesserung der Klebemassenverankerung erzielt wird. Ebenso können eine oder beide Seiten mit einer funktionalen Schicht ausgerüstet sein, die beispielsweise als Sperrschicht fungieren kann. Die Haftklebemasseschichten können optional mit Trennpapieren oder Trennfolien eingedeckt werden. Alternativ kann auch nur eine Klebemasseschicht mit einem doppelseitig trennenden Liner eingedeckt sein.

In einer Variante ist in dem doppelseitig (selbst)klebenden Klebeband eine erfindungsgemäße Klebemasse vorgesehen sowie eine beliebige weitere, zum Beispiel eine solche, die besonders gut auf einem Abdecksubstrat haftet oder eine besonders gute Repositionierbarkeit zeigt.

Des Weiteren sind die Klebemasse sowie ein eventuell damit gebildetes Klebeband hervorragend zur Kapselung einer elektronischen Anordnung gegen Permeate geeignet, indem die Klebemasse oder das Klebeband auf und/oder um die zu kapselnden Bereiche der elektronischen Anordnung appliziert werden.

Des Weiteren umfasst der erfinderische Gedanke eine Klebemasse, die insbesondere zur Kapselung einer elektronischen Anordnung gegen Permeate geeignet ist und die eine Mischung aus zumindest einem fluorhaltigen thermoplastischen Elastomer und zumindest einem fluorhaltigen flüssigen Elastomer sowie zumindest ein Klebharz enthält, wobei die Klebemasse vorzugsweise zu mindestens 70 Gew.-%, weiter vorzugsweise zu 90 Gew.-% (jeweils bezogen auf die Gesamtzusammensetzung der Haftklebemasse) diese Mischung enthält.

Gemäß einer bevorzugten Ausführungsform liegt auch das Massenverhältnis des fluorhaltigen flüssigen Elastomers zu dem fluorhaltigen thermoplastischen Elastomer zwischen 5:95 bis 55:45, vorzugsweise zwischen 15:75 und 50:50 und besonders bevorzugt zwischen 25:75 und 40:60.

Auch für diese Klebemasse gelten alle Ausführungsformen als vorteilhaft, wie sie bezüglich der ersten Klebemasse erwähnt worden sind - im Unterschied zu dieser ist nur zwingend zumindest ein Klebharz in einer Mischung aus zumindest einem fluorhaltigen thermoplastischen Elastomer und zumindest einem fluorhaltigen flüssigen Elastomer enthalten.

Als Kapselung wird vorliegend nicht nur ein vollumfänglicher Einschluss mit der genannten Haftklebemasse bezeichnet sondern auch bereits eine bereichsweise Applikation der Haftklebemasse auf den zu kapselnden Bereichen der (opto-) elektronischen Anordnung, beispielsweise eine einseitige Überdeckung oder eine Umrahmung einer elektronischen Struktur.

Im Prinzip können mit Klebebändern zwei Arten der Verkapselung durchgeführt werden. Entweder wird das Klebeband zuvor ausgestanzt und nur um die zu kapselnden Bereiche herum verklebt, oder es wird vollflächig über die zu kapselnden Bereiche geklebt. Ein Vorteil der zweiten Variante ist die einfachere Handhabung und der häufig bessere Schutz.

Bei amorphen Stoffen entspricht die Erweichungstemperatur dabei der Glasübergangstemperatur, bei (semi)kristallinen Stoffen entspricht die Erweichungstemperatur dabei der Schmelztemperatur.

Die Herstellung und Verarbeitung der Haftklebemasse kann aus Lösung, Dispersion sowie aus der Schmelze erfolgen. Bevorzugt erfolgt die Herstellung und Verarbeitung aus Lösung oder aus der Schmelze. Besonders bevorzugt ist die Fertigung der Klebmasse aus Lösung. Dabei werden die Bestandteile der Haftklebemasse in einem geeigneten Lösungsmittel, zum Beispiel Butanon gelöst und mit allgemein bekannten Verfahren auf den Träger aufgebracht. Bei der Verarbeitung aus der Schmelze können dies Auftragsverfahren über eine Düse oder einen Kalander sein. Bei Verfahren aus der Lösung sind Beschichtungen mit Rakeln, Messern, Walzen oder Düsen bekannt, um nur einige zu nennen.

Über die Beschichtungstemperatur kann in lösungsmittelfreien Prozessen das Beschichtungsergebnis beeinflusst werden. Dem Fachmann sind die Prozessparameter geläufig, um transparente Klebeschichten zu erhalten. In Lösungsmittelbeschichtungsprozessen kann über die Auswahl des Lösungsmittels oder des Lösungsmittelgemischs das Beschichtungsergebnis beeinflusst werden. Dem Fachmann ist auch hier geläufig, geeignete Lösungsmittel auszuwählen. Kombinationen aus Lösungsmitteln, die unter 100 °C sieden, mit Lösungsmitteln, die oberhalb 100 °C sieden, sind sehr gut geeignet.

Vorteilhaft ist die Beschichtung aus Lösungsmitteln oder aus der Schmelze. Hierfür bieten erfindungsgemäße Formulierungen große Vorteile, wie bereits weiter oben ausgeführt wurde.

Vorteil der hier vorliegenden Erfindung ist also, im Vergleich zu anderen Haftklebemassen, die Kombination aus sehr guten Barriereeigenschaften gegenüber Wasserdampf und vor allem gegenüber Sauerstoff bei gleichzeitiger guter Grenzflächenhaftung auf unterschiedlichen Substraten, guten kohäsiven Eigenschaften und, im Vergleich zu Flüssigklebstoffen, eine sehr hohe Flexibilität und eine einfache Applikation in der (opto-)elektronischen Anordnung und bei/in der Kapselung. Des Weiteren liegen in bestimmten Ausführungen auch hochtransparente Klebemassen vor, die in besonderer Weise für den Einsatz in (opto-)elektronischen Anordnungen Anwendung finden können, da eine Verminderung von einfallendem oder austretendem Licht sehr gering gehalten wird.

Eine Verkapselung durch Lamination von zumindest Teilen der (opto-)elektronischen Aufbauten mit einem flächigen Barrierematerial (zum Beispiel Glas, insbesondere Dünnglas, metalloxidbeschichteten Folien, Metallfolien, Multilayer-Substratmaterialien) ist mit sehr guter Barrierewirkung in einem einfachen Rolle-zu-Rolle Prozess möglich. Die Flexibilität des gesamten Aufbaus hängt, neben der Flexibilität der Haftklebemasse von weiteren Faktoren, wie Geometrie und Dicke der (opto-)elektronischen Aufbauten beziehungsweise der flächigen Barrierematerialien ab. Die hohe Flexibilität der Haftklebemasse ermöglicht es aber sehr dünne, biegsame und flexible (opto-)elektronische Aufbauten zu realisieren.

Von besonderem Vorteil für die Kapselung von (opto-)elektronischen Aufbauten ist es, wenn diese vor, während oder nach der Applikation der Haftklebemasse erwärmt werden. Dadurch kann die Haftklebemasse noch besser auffließen und somit die Permeation an der Grenzfläche zwischen der (opto-)elektronischen Anordnung und der Haftklebemasse weiter vermindert werden. Die Temperatur sollte dabei bevorzugt mehr als 30 °C, weiter bevorzugt mehr als 50 °C betragen, um das Auffließen entsprechend zu fördern. Zu hoch sollte die Temperatur jedoch nicht gewählt werden, um die (opto-)elektronische Anordnung nicht zu beschädigen. Die Temperatur sollte möglichst weniger als 100 °C betragen. Als optimaler Temperaturbereich haben sich Temperaturen zwischen 50 °C und 70 °C herausgestellt. Vorteilhaft ist es ebenso, wenn die Haftklebemasse vor, während oder nach der Applikation zusätzlich oder alternativ erwärmt wird.

Zusammengefasst erfüllt die erfindungsgemäße Klebemasse alle Anforderungen, wie sie an eine Klebemasse gestellt werden, die zur Verkapselung einer (opto-)elektronischen Anordnung eingesetzt wird:

- eine geringe Volumenpermeation von Wasserdampf und Sauerstoff, was sich in einem Wert für WVTR (Mocon) von kleiner 60 g/m$^2$ d, und einem Wert für OTR (Mocon) von kleiner 2500 cm$^3$/m$^2$*d*bar zeigt,
- eine geringe Grenzflächenpermeation von Wasserdampf und Sauerstoff, was sich in einem Wert für WVTR (Ca-Test) von kleiner 10 g/m$^2$ d zeigt und ein gutes Auffließen der Klebemasse auf die Zielsubstrate bedingt;

- optional, aber bevorzugt hohe Transparenz mit einer Transmission von bevorzugt über 90 %
- optional, aber bevorzugt ein Haze kleiner 5,0 % bevorzugt kleiner 2,5 %
- hervorragendes Laminationsverhalten zum Beispiel im Rolle-zu-Rolle-Prozess, was sich in einer Klebkraft für das unvernetzte System auf Glas größer 1,5 N/cm, bevorzugt größer 2,5 N/cm und einer dynamischen Scherfestigkeit für das vernetzte System auf Glas von größer 10 N/cm$^2$, bevorzugt größer 20 N/cm$^2$ zeigt
- sehr hohe UV- und Witterungsbeständigkeit, wie sie für (opto-)elekronische Anwendungen und insbesondere für Anwendungen wie etwa Solarzellen besonders vorteilhaft ist

Weitere Einzelheiten, Ziele, Merkmale und Vorteile der vorliegenden Erfindung werden nachfolgend anhand mehrerer, bevorzugte Ausführungsbeispiele darstellende Figuren näher erläutert. Es zeigen

Fig. 1     eine erste (opto-)elektronische Anordnung in schematischer Darstellung,

Fig. 2     eine zweite (opto-)elektronische Anordnung in schematischer Darstellung,

Fig. 3     eine dritte (opto-)elektronische Anordnung in schematischer Darstellung.

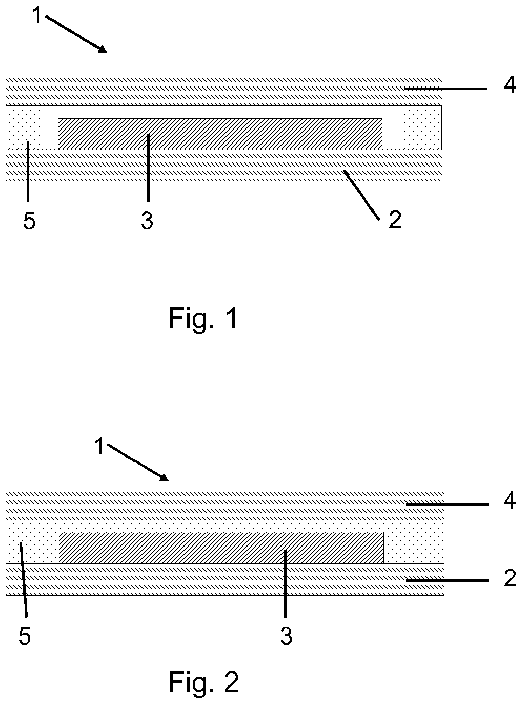

Fig. 1 zeigt eine erste Ausgestaltung einer (opto-)elektronischen Anordnung 1. Diese Anordnung 1 weist ein Substrat 2 auf, auf dem eine elektronische Struktur 3 angeordnet ist. Das Substrat 2 selbst ist als Barriere für Permeate ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.
Um die elektronische Struktur 3 auch zur Seite hin zu kapseln und gleichzeitig die Abdeckung 4 mit der elektronischen Anordnung 1 im Übrigen zu verbinden, ist eine Haftklebemasse 5 umlaufend neben der elektronischen Struktur 3 auf dem Substrat 2 vorgesehen. In anderen Ausführungsformen erfolgt die Kapselung nicht mit einer reinen Haftklebemasse 5, sondern mit einem Klebeband 5, das zumindest eine erfindungsgemäße Haftklebemasse enthält. Die Haftklebemasse 5 verbindet die Abdeckung 4 mit dem Substrat 2. Durch eine entsprechend dicke Ausgestaltung ermöglicht die Haftklebemasse 5 zudem die Beabstandung der Abdeckung 4 von der elektronischen Struktur 3.
Bei der Haftklebemasse 5 handelt es sich um eine solche auf Basis der erfindungsgemäßen Haftklebemasse wie sie vorstehend in allgemeiner Form beschrieben wurde und nachfolgend in Ausführungsbeispielen näher dargelegt ist. Die Haftklebemasse 5 übernimmt vorliegend nicht nur die Funktion des Verbindens des Substrats 2 mit der Abdeckung 4 sondern bildet zudem auch eine Barriereschicht für Permeate bereit, um so die elektronische Struktur 3 auch von der Seite gegen Permeate wie Wasserdampf und Sauerstoff zu kapseln.
Die Haftklebemasse 5 wird vorliegend zudem in Form eines Stanzlings aus einem doppelseitigen Klebebandes bereitgestellt. Ein derartiger Stanzling ermöglicht eine besonders einfache Applikation.
Fig. 2 zeigt eine alternative Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun die Haftklebemasse 5 vollflächig angeordnet. Die elektronische Struktur 3 wird somit von oben vollständig durch die Haftklebemasse 5 gekapselt. Auf die Haftklebemasse 5 ist sodann eine Abdeckung 4 aufgebracht. Diese Abdeckung 4 muss im Gegensatz zu der vorherigen Ausgestaltung nicht zwingend die hohen Barriereanforderungen erfüllen, da die Barriere bereits durch die Haftklebemasse bereitgestellt wird. Die Abdeckung 4 kann beispielsweise lediglich eine mechanische Schutzfunktion wahrnehmen, sie kann aber auch zusätzlich als Permeationsbarriere vorgesehen sein.

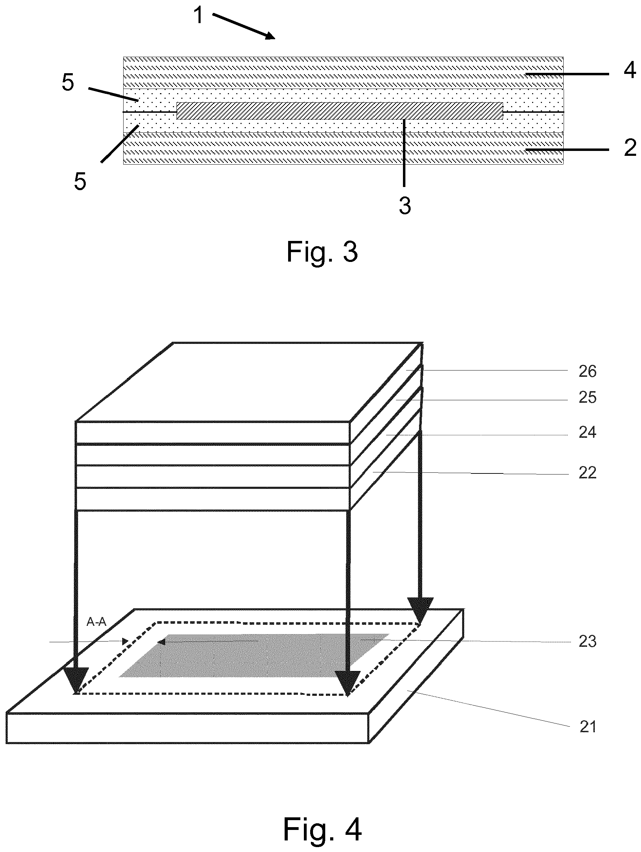

Fig. 3 zeigt eine weitere alternative Ausgestaltung einer (opto-)elektronischen Anordnung 1. Im Gegensatz zu den vorherigen Ausgestaltungen sind nun zwei Haftklebemassen 5a, 5b vorgesehen, die vorliegend identisch ausgebildet sind. Die erste Haftklebemasse 5a ist vollflächig auf dem Substrat 2 angeordnet. Auf der Haftklebemasse 5a ist die elektronische Struktur 3 vorgesehen, die durch die Haftklebemasse 5a fixiert wird. Der Verbund aus Haftklebemasse 5a und elektronischer Struktur 3 wird dann mit der weiteren Haftklebemasse 5b vollflächig überdeckt, so dass die elektronische Struktur 3 von allen Seiten durch die Haftklebemassen 5a, b gekapselt ist. Oberhalb der Haftklebemasse 5b ist wiederum die Abdeckung 4 vorgesehen.
In dieser Ausgestaltung müssen somit weder das Substrat 2 noch die Abdeckung 4 zwingend Barriereeigenschaften aufweisen. Sie können aber dennoch vorgesehen sein, um die Permeation von Permeaten zur elektronischen Struktur 3 weiter einzuschränken.
Insbesondere im Hinblick auf die Fig. 2, 3 wird darauf hingewiesen, dass es sich vorliegend um schematische Darstellungen handelt. Aus den Darstellungen ist insbesondere nicht ersichtlich, dass die Haftklebemasse 5 hier und vorzugsweise jeweils mit einer homogenen Schichtdicke aufgetragen wird. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Gegebenenfalls kann jedoch auch eine Anpassung an den Untergrund erfolgen, insbesondere dann, wenn die Applikation unter Vakuum oder unter erhöhtem Druck durchgeführt wird. Zudem wird die Haftklebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 $\mu$m dick).

Die Applikation der Haftklebemasse 5 erfolgt in allen gezeigten Ausführungsbeispielen in Form eines Haftklebebandes. Dabei kann es sich grundsätzlich um ein doppelseitiges Haftklebeband mit einem Träger oder um ein Transferklebeband handeln. Vorliegend ist eine Ausgestaltung als Transferklebeband gewählt.

Die Dicke der Haftklebemasse, die entweder als Transferklebeband oder auf einem flächigen Gebilde beschichtet vorliegt, beträgt bevorzugt zwischen etwa 1 $\mu$m und etwa 150 $\mu$m, weiter bevorzugt zwischen etwa 5 $\mu$m und etwa 75 $\mu$m und besonders bevorzugt zwischen etwa 12 $\mu$m und 50 $\mu$m. Hohe Schichtdicken zwischen 50 $\mu$m und 150 $\mu$m werden dann eingesetzt wenn eine verbesserte Haftung auf dem Substrat und/oder eine dämpfende Wirkung innerhalb des (opto-)elektronischen Aufbaus erreicht werden soll. Nachteilig ist hier jedoch der erhöhte Permeationsquerschnitt. Geringe Schichtdicken zwischen 1 $\mu$m und 12 $\mu$m reduzieren den Permeationsquerschnitt, damit die laterale Permeation und die Gesamtdicke des (opto-)elektronischen Aufbaus. Jedoch kommt es zu einer Verringerung der Haftung aus dem Substrat. In den besonders bevorzugten Dickenbereichen liegt ein guter Kompromiss zwischen einer geringen Massendicke und dem daraus folgenden niedrigen Permeationsquerschnitt, der die laterale Permeation verringert, und einem genügend dicken Massefilm zur Herstellung einer ausreichend haftenden Verbindung. Die optimale Dicke hängt vom (opto-)elektronischen Aufbau, der Endanwendung, der Art der Ausführung der Haftklebemasse und gegebenenfalls dem flächigen Substrat ab.

Für doppelseitige Klebebänder gilt für die Barriereklebemasse(n) ebenfalls, dass die Dicke der einzelnen Haftklebemasseschicht(en) bevorzugt zwischen etwa 1 $\mu$m und etwa 150 $\mu$m, weiter bevorzugt zwischen etwa 5 $\mu$m und etwa 75 $\mu$m und besonders bevorzugt zwischen etwa 12 $\mu$m und 50 $\mu$m liegt. Kommt in doppelseitigen Klebebändern neben der einen erfindungsgemäßen Barriereklebemasse eine weitere zum Einsatz, dann kann es auch vorteilhaft sein, wenn ihre Dicke oberhalb 150 $\mu$m liegt.

Im Folgenden wird die Erfindung durch einige Beispiele näher erläutert, ohne die Erfindung damit einschränken zu wollen.

**Prüfmethoden**

*Klebkraft*

Die Klebkräfte auf Stahl wurden analog ISO 29862 (Methode 3) bei 23 °C und 50 % relativer Luftfeuchte bei einer Abzugsgeschwindigkeit von 300 mm/min und einem Abzugswinkel von 180° bestimmt. Als Verstärkungsfolie wurde eine geätzte PET-Folie mit einer Dicke von 50 $\mu$m verwendet, wie sie von der Firma Coveme (Italien) erhältlich ist. Die Verklebung des Messstreifens wurde dabei mittels einer Anrollmaschine bei einer Temperatur von 23 °C vorgenommen. Die Klebebänder wurden sofort nach der Applikation abgezogen.

*ShearAdhesion Failure Temperature (SAFT)*

Die Bestimmung der SAFT wurde wie folgt durchgeführt: Als definierter Haftgrund wurde eine polierte Stahlfläche eingesetzt. Das zu untersuchende verklebbare Flächenelement wurde auf eine Breite von 10 mm und eine Länge von etwa 5 cm zugeschnitten und unmittelbar danach dreimal mit einer Stahlrolle von 2 kg bei einem Vorschub von 10 m/min auf den jeweils gewählten Haftgrund mit einer Fläche von 10 x 13 mm aufgedrückt. Unmittelbar im Anschluss daran wurde das zuvor verklebte Flächenelement in einem Winkel von 180° mit 0,5 N belastet und eine Temperaturrampe von 9 °C/min gefahren. Dabei wurde die Temperatur gemessen, bei der die Probe eine Rutschstrecke von 1 mm zurückgelegt hat. Der Messwert (in °C) ergibt sich als Mittelwert aus zwei Einzelmessungen.

*Permeabilität für Sauerstoff (OTR) und Wasserdampf (WVTR)*

Die Bestimmung der Permeabilität für Sauerstoff (OTR) und Wasserdampf (WVTR) erfolgt nach DIN 53380 Teil 3 beziehungsweise ASTM F-1249. Die Haftklebemasse wird dazu mit einer Schichtdicke von 50 $\mu$m auf eine permeable Membran aufgebracht. Die Sauerstoffdurchlässigkeit wird bei 23 °C und einer relativen Feuchte von 50 % gemessen mit einem Messgerät Mocon OX-Tran 2/21. Die Wasserdampfdurchlässigkeit wird bei 37,5 °C und einer relativen Feuchte von 90 % bestimmt.

*Transmission*

Die Transmission der Klebemasse wurde analog ASTM D1003-11 (Procedure A (Hazemeter Byk Hazeguard Dual), Normlichtart D65) bestimmt. Eine Korrektur von Grenzflächenreflextionsverlusten wird nicht vorgenommen

*HAZE-Messung*

Der HAZE-Wert beschreibt den Anteil des transmittierten Lichts, der von der durchstrahlten Probe nach vorne großwinklig gestreut wird. Somit quantifiziert der HAZE-Wert Materialfehler in der Oberfläche oder der Struktur, die die klare Durchsicht stören.
Das Verfahren zur Messung des Haze-Wertes wird in der Norm ASTM D 1003 beschrieben. Die Norm erfordert die Messung von vier Transmissionsmessungen. Für jede Transmissionsmessung wird der Lichttransmissionsgrad berechnet. Die vier Transmissionsgrade werden zum prozentualen Haze-Wert verrechnet. Der HAZE-Wert wird mit einem Hazeguard Dual von Byk-Gardner GmbH gemessen.

*Permeation*

Die Bestimmung der Permeabilität für Sauerstoff (OTR) und Wasserdampf (WVTR) erfolgte nach DIN 53380 Teil 3 bzw. ASTM F-1249. Die Heißschmelzklebemasse wurde dazu mit einer Schichtdicke von 50 $\mu$m ohne Trägermaterial vermessen. Für die Sauerstoffdurchlässigkeit wurde bei 23°C und einer relativen Feuchte von 50 % gemessen. Die Wasserdampfdurchlässigkeit wurde bei 37,5°C und einer relativen Feuchte von 90 % bestimmt.

*Lebensdauertest*

Als ein Maß für die Bestimmung der Lebensdauer eines elektronischen Aufbaus wurde ein Calciumtest herangezogen. Dieser ist in der Figur 4 gezeigt. Dazu wird im Vakuum eine 20 x 20 mm$^2$ große, dünne Calciumschicht 23 auf eine Glasplatte 21 abgeschieden und danach unter Stickstoffatmosphäre gelagert. Die Dicke der Calciumschicht 23 liegt bei etwa 100 nm. Für die Verkapselung der Calciumschicht 23 wird ein Klebeband (26 x 26 mm$^2$) mit der zu testenden Klebemasse 22 sowie einer Dünnglasscheibe 24 (35 $\mu$m, Firma Schott) als Trägermaterial verwendet. Zur Stabilisierung war die Dünnglasscheibe mit einer 100 $\mu$m dicken PET-Folie 26 mittels eines 50 $\mu$m dicken Transferklebebands 25 einer optisch hochtransparenten Acrylathaftklebemasse laminiert. Die Klebemasse 22 wird so auf der Glasplatte 21 appliziert, dass die Klebemasse 22 den Calciumspiegel 23 mit einem allseitig überstehenden Rand von 3 mm (A-A) abdeckt. Aufgrund des undurchlässigen Glasträgers 24 wird nur die Permeation durch den Haftkleber ermittelt.
Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Fläche des Calciumspiegels als Lebensdauer bezeichnet. Als Messbedingungen werden 60 °C und 90 % relative Luftfeuchte gewählt. Die Muster wurden mit einer Schichtdicke der Haftklebemasse von 50 $\mu$m vollflächig und blasenfrei verklebt. Der Messwert (in h) ergab sich als Mittelwert aus drei Einzelmessungen.

*Witterungsbeständigkeit und Gelbwertmessung*

Als Maß für die Witterungsbeständigkeit wird eine Kurzzeitbewitterung mittels Xenonbogenlampe, deren Spektrum und Bestrahlungsstärke dem Sonnenlicht ähnlich sind, herangezogen. Zusätzlich wird eine periodische Besprühung mit Wasser durchgeführt. Die Durchführung erfolgt nach ISO 4892-2 (Method A, Cycle No.2), die gesamte Testdauer beträgt 1000 Stunden. Die Haftklebemasse wird dazu zwischen zwei ETFE-Folien (Nowoflon ET, 50$\mu$m) verklebt. Als Referenzprobe wird die Folie ebenfalls ohne Haftklebemasse unter oben genannten Bedingungen gelagert.
Die Proben werden jeweils nach 100, 500 und 100 0h mittels Messung des Gelbwertes b* ausgewertet (DIN EN ISO 11664). Der Test gilt als bestanden, falls $\Delta$b* < 1,0 nach 1000 h Bewitterung. Falls dieser Schwellenwert schon früher erreicht wird, wird die erreichte Stundenzahl als Ergebnis angegeben. Das Muster wird gegen einen weißen Standarduntergrund (b* < 2,0) gemessen. Der Gelbwert der ETFE-Folie wird bei der Auswertung ebenfalls berücksichtigt. Standarduntergrund und Folienvergilbung werden aus den angegebenen Gelbwerten herausgerechnet.

*MMAP und DACP*

MMAP ist der gemischte-Methylcyclohexan-Anilin-Trübungspunkt, der unter Verwendung eines modifizierten ASTM C 611-Verfahrens bestimmt wird. Methylcyclohexan ist für das in dem Standard-Prüfverfahren verwendete Heptan eingesetzt. Das Verfahren verwendet Harz/Anilin/Methylcyclohexan in einem Verhältnis von 1/2/1 (5 g/10 ml/5 ml), und der Trübungspunkt wird bestimmt durch Abkühlen einer erhitzten, klaren Mischung der drei Komponenten, bis die vollständige Trübung gerade eintritt.

Der DACP ist der Diaceton-Trübungspunkt und wird durch Abkühlen einer erhitzten Lösung von 5 g Harz, 5 g Xylol und 5 g Diacetonalkohol bis zu dem Punkt bestimmt, bei welchem die Lösung trübe wird.

Sofern nicht anders angegeben, sind alle Mengenangaben in den nachfolgenden Beispielen Gewichtsprozente beziehungsweise Gewichtsteile bezogen auf die Gesamtzusammensetzung.

Alle Rohstoffe wurden bei Raumtemperatur in Butanon mit einem Feststoffanteil von 40 % gelöst. Mittels eines Rakelverfahrens wurde die Formulierung aus Lösung auf einen silikonisierten PET-Liner beschichtet und bei 120 °C für 10 min vernetzt und getrocknet. Der Masseauftrag betrug 50 g/m$^2$. Das Muster wurde mit einer weiteren Lage eines silikonisierten aber leichter trennenden PET-Liners eingedeckt.

Für die Klebkraftmessung wurde der Klebefilm auf einem Stahluntergrund verklebt.

Rohstoffe:

thermoplastisches Fluorelastomer Dai-El G7400BP der Firma Daikin Industries Ltd.

- Fluorgehalt: 66%

flüssiges Fluorelastomer Dai-El G-101 der Firma Daikin Industries Ltd.

- Fluorgehalt: 66%

thermoplastisches Fluorelastomer Viton A-100 der Firma DuPont

- Fluorgehalt: 66%

Foral 85 von der Firma Eastman,

- hydrierter Rosinester
- Ring and Ball Softening Point 85 °C
- MMAP 7 °C
- DACP < -60 °C

Magnesiumoxid, bezogen von Sigma-Aldrich (599649)

- <50 nm particle size (BET)

DBU, bezogen von Sigma Aldrich (139009)

- 1,8-Diazabicyclo[5.4.0]undec-7-en

Epikure 925 von der Firma Momentive Specialty Chemicals

- Triethylene Tetraamin

Hexamethylendiamine, bezogen von Sigma-Aldrich (422002)

- 1,6-Hexanediamine

Beispiel 1:

| | |
|---|---|
| thermoplastisches Fluorelastomer Daikin Dai-El G7400 | 95 Gew.-% |
| flüssiges Fluorelastomer Daikin Dai-El G-101 | 5 Gew. % |

Beispiel 2:
* thermoplastisches Fluorelastomer Daikin Dai-El G7400    80 Gew.-%
flüssiges Fluorelastomer Daikin Dai-El G-101    20 Gew. %

Beispiel 3:
* thermoplastisches Fluorelastomer Daikin Dai-El G7400    60 Gew.-%
flüssiges Fluorelastomer Daikin Dai-El G-101    40 Gew. %

Beispiel 4:
* thermoplastisches Fluorelastomer Viton A-100    60 Gew.-%
flüssiges Fluorelastomer Daikin Dai-El G-101    40 Gew. %

Beispiel 5:
thermoplastisches Fluorelastomer Daikin Dai-El G7400    50 Gew.-%
flüssiges Fluorelastomer Daikin Dai-El G-101    40 Gew. %
Foral 85, hydrierte Rosinester    10 Gew. %

Beispiel 6:
* thermoplastisches Fluorelastomer Daikin Dai-El G7400    60 Gew.-%
flüssiges Fluorelastomer Daikin Dai-El G-101    37,9 Gew. %
DBU    0,1 Gew. %
Epikure 925    1,0 Gew.%
MgO (Nanopowder, 50nm)    1,0 Gew.%

Beispiel 7:
* thermoplastisches Fluorelastomer Daikin Dai-El G7400    60 Gew.-%
flüssiges Fluorelastomer Daikin Dai-El G-101    37,9 Gew. %
DBU    0,1 Gew. %
Hexamethylene Diamine    1,0 Gew.%
MgO (Nanopowder, 50nm)    1,0 Gew.%

Beispiel 8:
thermoplastisches Fluorelastomer Daikin Dai-El G7400    50 Gew.-%
flüssiges Fluorelastomer Daikin Dai-El G-101    37,5 Gew. %
Foral 85, hydrierte Rosinester    10 Gew. %
DBU    0,1 Gew. %
Epikure 925    1,0 Gew.%
MgO (Nanopowder, 50nm)    1,0 Gew.%

Beispiel 9:
* thermoplastisches Fluorelastomer Daikin Dai-El G7400    40 Gew.-%
flüssiges Fluorelastomer Daikin Dai-El G-101    60 Gew. %

Beispiel 10:
* thermoplastisches Fluorelastomer Daikin Dai-El G7400    20 Gew.-%
flüssiges Fluorelastomer Daikin Dai-El G-101    80 Gew. %

Beispiel 11:
thermoplastisches Fluorelastomer Daikin Dai-El G7400    36 Gew.-%
flüssiges Fluorelastomer Daikin Dai-El G-101    54 Gew. %
Foral 85, hydrierte Rosinester    10 Gew.-%

Vergleichsbeispiel V1:
SIS Vector 4113 der Firma Dexco    45 Gew.-%
Hydriertes KW-Harz Escorez 5600 der Firma Exxon    45 Gew.-%
Weißöl Ondina G17 der Firma Shell    10 Gew.-%

* Nicht erfindungsgemäß

| Beispiel | Klebkraft Stahl [N/cm] | SAFT [°C] | WVTR [g/m$^2$d] | OTR [g/m$^2$d bar] | Lebensdauer [h] | Witterungsbeständigkeit [h] |
|---|---|---|---|---|---|---|
| 1 | 1,1 | 172 | 39 | 1400 | 270 | bestanden |
| 2 | 1,4 | 160 | 45 | 1800 | 220 | bestanden |
| 3 | 3,5 | 130 | 56 | 2200 | 200 | bestanden |
| 4 | 3,7 | 120 | 52 | 2300 | 210 | bestanden |
| 5 | 3,2 | 120 | 28 | 800 | 390 | bestanden |
| 6 | 3,1 | > 200 | 52 | 1800 | 230 | bestanden |
| 7 | 3,5 | > 200 | 53 | 1750 | 220 | bestanden |
| 8 | 3,2 | > 200 | 25 | 680 | 420 | bestanden |
| 9 | 5,2 | 80 | 75 | 3500 | 170 | bestanden |
| 10 | 6,1 | 60 | 87 | 6800 | 150 | bestanden |
| 11 | 6,2 | 87 | 41 | 950 | 370 | bestanden |
| V1 | 9,5 | 110 | 42 | 4300 | 220 | < 100h |

Die Klebemassen zeigen somit eine hervorragende Eignung für die Verkapselung organischer elektronischer Aufbauten.

Bei den Beispielen 1 bis 8 ist eine erhöhte Scherfestigkeit (siehe Ergebnisse des SAFT-Tests) zu erkennen. Diese Klebemassen eignen sich also ganz besonders für die Verkapselung auch empfindlicher elektronischer Anordnungen, insbesondere falls eine hohe Langzeitbeständigkeit gefordert wird. Eine hohe Scherfestigkeit ist vorteilhaft, damit bei Lagerung bei hohen Temperaturen und Feuchte, zum Beispiel 85 °C und 85 % relativer Feuchte, keine Blasenbildung im elektronischen Aufbau oder beim Lebensdauertest auftritt.

Erfindungsgemäß geeignet sind auch die Beispiele 9 bis 11, und zwar insbesondere für weniger gegen Wasserdampf oder Sauerstoff empfindliche Solarzellen wie beispielsweise anorganische Dünnschichtsolarzellen oder Farbstoffsolarzellen.

Die Beispiele 6 bis 8 sind vernetzt, was zu einer signifikanten Erhöhung der Scherfestigkeit und der Barrierewirkung gegen Wasserdampf und insbesondere gegen Sauerstoff führt, wodurch diese besonders für sehr empfindliche (opto-)elektronische Aufbauten mit hoher Langzeitbeständigkeit geeignet sind.

Aus den Beispielen 5, 8 und 11 lässt sich ableiten, dass der Zusatz von Klebharzen die Werte für WVTR und OTR steigen lässt, also die Barriereeigenschaften weiter verbessert.

**Patentansprüche**

1. Haftklebemasse zur Kapselung einer elektronischen Anordnung gegen Permeate, die eine Mischung aus zumindest einem fluorhaltigen thermoplastischen Elastomer und zumindest einem fluorhaltigen flüssigen Elastomer enthält, **dadurch gekennzeichnet, dass** die Haftklebemasse ferner zumindest ein zumindest teilhydriertes Klebharz enthält.

2. Haftklebemasse nach Anspruch 1, **dadurch gekennzeichnet, dass** die Haftklebemasse zu mindestens 70 Gew.-%, vorzugsweise zu 90 Gew.-% (jeweils bezogen auf die Gesamtzusammensetzung der Haftklebemasse) diese Mischung enthält.

3. Haftklebemasse nach Anspruch 1 oder 2, **dadurch gekennzeichnet, dass** das Massenverhältnis des fluorhaltigen flüssigen Elastomers zu dem fluorhaltigen thermoplastischen Elastomer zwischen 5:95 bis 55:45, vorzugsweise zwischen 15:75 und 50:50 und besonders bevorzugt zwischen 25:75 und 40:60 liegt.

4. Haftklebemasse nach einem der Ansprüche 1 bis 3, **dadurch gekennzeichnet, dass** das oder die fluorhaltigen thermoplastischen Elastomer(e) ein fluorhaltiges Elastomer umfassen mit (i) mindestens einem weichen Segment, bestehend aus einem Terpolymer aus Vinylidenfluorid/Hexafluorpropylen/Tetrafluorethylen oder Vinylidenfluorid/Chlortrifluorethylen/Tetrafluorethylen, und (ii) mindestens einem harten Segment, bestehend aus (a) einem Copolymer aus Tetrafluorethylen/Ethylen oder Chlortrifluorethylen/Ethylen oder (b) aus Polyvinylidenfluorid.

5. Haftklebemasse nach zumindest einem der vorhergehenden Ansprüche, **dadurch gekennzeichnet, dass** das oder die fluorhaltigen thermoplastischen Elastomer(e) ein fluorhaltiges Elastomer umfassen mit (i) mindestens einem weichen Segment aus einem Copolymer aus Tetrafluorethylen/Propylen und (ii) mindestens einem harten Segment aus einem Copolymer aus Tetrafluorethylen/Ethylen.

6. Haftklebemasse nach zumindest einem der vorhergehenden Ansprüche, **dadurch gekennzeichnet, dass** das oder die fluorhaltigen thermoplastischen Elastomer(e) ein fluorhaltiges Elastomer umfassen mit (i) mindestens einem weichen Segment aus einem amorphen kautschukartigen Copolymer aus Tetrafluorethylen/Perfluoralkylvinylether und (ii) mindestens einem harten Segment aus einem Copolymer aus Tetrafluorethylen/Perfluoralkylvinylether, worin der Gehalt an Perfluoralkylvinylether geringer ist als im weichen Segment.

7. Haftklebemasse nach zumindest einem der vorhergehenden Ansprüche, **dadurch gekennzeichnet, dass** das thermoplastische fluorhaltige Elastomer verträglich mit dem fluorhaltigen flüssigen Elastomer ist.

8. Haftklebemasse nach zumindest einem der vorhergehenden Ansprüche, **dadurch gekennzeichnet, dass** die Haftklebemasse die Kombination (i) eines fluorhaltigen flüssigen Elastomers aus Vinylidenfluorid, Hexafluorpropylen und Tetrafluorethylen und (ii) eines fluorhaltigen thermoplastischen Elastomers, das ein weiches Segment aus demselben Terpolymer wie das flüssige Elastomer umfasst, enthält.

9. Haftklebemasse nach zumindest einem der Ansprüche 1 bis 7, **dadurch gekennzeichnet, dass** die Haftklebemasse die Kombination (i) eines fluorhaltigen flüssigen Elastomers, das ein Tetrafluorethylen/Propylencopolymer oder ein Tetrafluorethylen/Perfluorpropylvinylethercopolymer ist, und (ii) eines fluorhaltigen thermoplastischen Elastomeren mit einem weichen Segment aus demselben Copolymer wie das Flüssigelastomer enthält.

**10.** Haftklebemasse nach zumindest einem der vorhergehenden Ansprüche,
**dadurch gekennzeichnet, dass**
als fluorhaltige flüssige Elastomere Elastomere auf Grundlage von Vinylidenfluorid/Hexafluorpropylen, von Vinylidenfluorid/Hexafluorpropylen/ Tetrafluorethylen, von Tetrafluorethylen/Propylen, von Hexafluorpropylen/Ethylen, Fluorsilicon-Elastomere und/oder fluor-substituierte Phosphazen-Elastomere verwendet werden.

**11.** Haftklebemasse nach zumindest einem der vorhergehenden Ansprüche, **dadurch gekennzeichnet, dass**
die Haftklebemasse vernetzt ist, vorzugsweise über eine aminische Vernetzung oder über eine Vernetzung mit einem Bisphenol (wie zum Beispiel Bisphenol AF) oder über eine Vernetzung mit Peroxiden.

**12.** Haftklebemasse nach zumindest einem der vorhergehenden Ansprüche, **dadurch gekennzeichnet, dass**
die Haftklebemasse ein oder mehrere Additive enthält,
vorzugsweise ausgewählt aus der Gruppe bestehend aus Plastifizierungsmitteln, primären Antioxidantien, sekundären Antioxidantien, Prozessstabilisatoren, Lichtschutzmitteln, Verarbeitungshilfsmittel, Endblockverstärkerharzen, Polymeren, insbesondere elastomerer Natur.

**13.** Haftklebemasse nach zumindest einem der vorhergehenden Ansprüche, **dadurch gekennzeichnet, dass**
die Haftklebemasse einen oder mehrere Füllstoffe enthält,
vorzugsweise nanoskalige Füllstoffe, transparente Füllstoffe und/oder Getter-und/oder Scavenger-Füllstoffe.

**14.** Haftklebemasse nach zumindest einem der vorhergehenden Ansprüche, **dadurch gekennzeichnet, dass**
die Haftklebemasse im sichtbaren Licht des Spektrums (Wellenlängenbereich von etwa 400 nm bis 800 nm) transparent ist und eine Transmission von größer als 75 % bei einer Wellenlänge von 400nm bis 800 nm aufweist.

**15.** Haftklebemasse nach zumindest einem der vorhergehenden Ansprüche, **dadurch gekennzeichnet, dass**
die Haftklebemasse einen Haze kleiner 5,0 %, bevorzugt kleiner 2,5 % zeigt, gemäß ASTM D 1003, gemessen mit einem Hazeguard Dual von Byk Gardener GmbH.

**16.** Haftklebemasse nach zumindest einem der vorhergehenden Ansprüche, **dadurch gekennzeichnet, dass**
als Klebharz partiell oder vollständig hydriertes Harz auf Basis von Kolophonium und Kolophoniumderivaten, hydriertes Polymerisat des Dicyclopentadiens, partiell, selektiv oder vollständig hydriertes Kohlenwasserstoffharz auf Basis von $C_5$-, $C_5/C_9$- oder $C_9$-Monomerströmen, Polyterpenharz auf Basis von $\alpha$-Pinen und/oder ß-Pinen und/oder $\delta$-Limonen, hydriertes Polymerisat von C8- und C9-Aromaten oder ein Gemisch davon eingesetzt wird.

**17.** Haftklebemasse nach Anspruch 16, **dadurch gekennzeichnet, dass**
als partiell oder vollständig hydriertes Harz auf Basis von Kolophonium und Kolophoniumderivaten Glycerinester von vollhydriertem Kolophonium eingesetzt wird.

**18.** Verwendung einer Haftklebemasse zur Kapselung einer (opto-)elektronischen Anordnung gegen Permeate,
**dadurch gekennzeichnet, dass**
die Haftklebemasse eine Haftklebemasse nach zumindest einem der vorhergehenden Ansprüche ist.

**19.** Verwendung nach Anspruch 18, **dadurch gekennzeichnet, dass**
zur Kapselung der (opto-)elektronischen Anordnung gegen Permeate ein mit der Haftklebemasse gebildetes ein- oder doppelseitig klebendes Klebeband verwendet wird.

**20.** Verwendung nach Anspruch 18 oder 19, **dadurch gekennzeichnet, dass**
die Haftklebemasse und/oder die zu kapselnden Bereiche der elektronischen Anordnung vor, während und/oder nach der Applikation der Haftklebemasse erwärmt werden.

**21.** Verwendung nach zumindest einem der Ansprüche 18 bis 20, **dadurch gekennzeichnet, dass**
die Haftklebemasse nach der Applikation auf der elektronischen Anordnung teil- oder endvernetzt wird.

**22.** Elektronische Anordnung mit einer elektronischen Struktur und einer Haftklebmasse, wobei die elektronische Struktur zumindest teilweise durch die Haftklebmasse gekapselt ist,
**dadurch gekennzeichnet,**
**dass** die Haftklebmasse gemäß zumindest einem der vorherigen Ansprüche ausgebildet ist.

**23.** Elektronische Anordnung nach Anspruch 22, **dadurch gekennzeichnet, dass**
die elektronische Struktur eine organische elektronische Struktur ist.

**Claims**

**1.** Pressure-sensitive adhesive for encapsulating an electronic arrangement with respect to permeants, comprising a mixture of at least one fluorine-containing thermoplastic elastomer and at least one fluorine-containing liquid elastomer,
**characterized in that**
the pressure-sensitive adhesive further comprises at least one at least partly hydrogenated tackifier resin.

**2.** Pressure-sensitive adhesive (PSA) according to Claim 1,
**characterized in that**
the pressure-sensitive adhesive comprises this mixture to an extent of at least 70 wt%, preferably to an extent of 90 wt% (based in each case on the overall composition of the pressure-sensitive adhesive).

**3.** Pressure-sensitive adhesive according to Claim 1 or 2,
**characterized in that**
the mass ratio of the fluorine-containing liquid elastomer to the fluorine-containing thermoplastic elastomer is between 5:95 to 55:45, preferably between 15:75 and 50:50, and more preferably between 25:75 and 40:60.

**4.** Pressure-sensitive adhesive according to one of Claims 1 to 3,
**characterized in that**
the fluorine-containing thermoplastic elastomer or elastomers comprise a fluorine-containing elastomer having (i) at least one soft segment, consisting of a terpolymer of vinylidene fluoride/hexafluoropropylene/tetrafluoroethylene or vinylidene fluoride/chlorotrifluoroethylene/tetrafluoroethylene, and (ii) at least one hard segment, consisting of (a) a copolymer of tetrafluoroethylene/ethylene or chlorotrifluoroethylene/ethylene or (b) of polyvinylidene fluoride.

**5.** Pressure-sensitive adhesive according to at least one of the preceding claims,
**characterized in that**
the fluorine-containing thermoplastic elastomer or elastomers comprise a fluorine-containing elastomer having (i) at least one soft segment composed of a copolymer of tetrafluoroethylene/propylene and (ii) at least one hard segment composed of a copolymer of tetrafluoroethylene/ethylene.

**6.** Pressure-sensitive adhesive according to at least one of the preceding claims,
**characterized in that**
the fluorine-containing thermoplastic elastomer or elastomers comprise a fluorine-containing elastomer having (i) at least one soft segment composed of an amorphous rubberlike copolymer of tetrafluoroethylene/perfluoroalkyl vinyl ether and (ii) at least one hard segment composed of a copolymer of tetrafluoroethylene/perfluoroalkyl vinyl ether in which the amount of perfluoroalkyl vinyl ether is less than in the soft segment.

**7.** Pressure-sensitive adhesive according to at least one of the preceding claims,
**characterized in that**
the thermoplastic fluorine-containing elastomer is compatible with the fluorine-containing liquid elastomer.

**8.** Pressure-sensitive adhesive according to at least one of the preceding claims,
**characterized in that**
the PSA comprises the combination (i) of a fluorine-containing liquid elastomer composed of vinylidene fluoride, hexafluoropropylene, and tetrafluoroethylene and (ii) of a fluorine-containing thermoplastic elastomer which comprises a soft segment composed of the same terpolymer as the liquid elastomer.

**9.** Pressure-sensitive adhesive according to at least one of Claims 1 to 7,
**characterized in that**
the PSA comprises the combination (i) of a fluorine-containing liquid elastomer which is a tetrafluoroethylene/propylene copolymer or a tetrafluoroethylene/perfluoropropyl vinyl ether copolymer, and (ii) of a fluorine-containing thermoplastic elastomer having a soft segment composed of the same copolymer as the liquid elastomer.

**10.** Pressure-sensitive adhesive according to at least one of the preceding claims,
**characterized in that**
fluorine-containing liquid elastomers used are elastomers based on vinylidene fluoride/hexafluoropropylene, on vinylidene fluoride/hexafluoropropylene/tetrafluoroethylene, on tetrafluoroethylene/propylene, on hexafluoropropylene/ethylene, fluorosilicone elastomers and/or fluorine-substituted phosphazene elastomers.

**11.** Pressure-sensitive adhesive according to at least one of the preceding claims,
**characterized in that**
the pressure-sensitive adhesive is crosslinked, preferably via aminic crosslinking or via crosslinking with a bisphenol (such as bisphenol AF, for example) or via crosslinking with peroxides.

**12.** Pressure-sensitive adhesive according to at least one of the preceding claims,
**characterized in that**
the pressure-sensitive adhesive comprises one or more additives,
preferably selected from the group consisting of plasticizers, primary antioxidants, secondary antioxidants, process stabilizers, light stabilizers, processing assistants, endblock reinforcer resins, polymers, more particularly elastomeric in nature.

**13.** Pressure-sensitive adhesive according to at least one of the preceding claims,
**characterized in that**
the pressure-sensitive adhesive comprises one or more fillers,
preferably nanoscale fillers, transparent fillers and/or getter and/or scavenger fillers.

**14.** The pressure-sensitive adhesive according to at least one of the preceding claims,
**characterized in that**
the pressure-sensitive adhesive is transparent in the visible light of the spectrum (wavelength range from about 400 nm to 800 nm) and has a transmittance of more than 75% at a wavelength of 400 nm to 800 nm.

**15.** Pressure-sensitive adhesive according to at least one of the preceding claims,
**characterized in that**
the pressure-sensitive adhesive exhibits a haze of less than 5.0%, preferably less than 2.5%, according to ASTM D 1003, measured with a Hazeguard Dual from Byk Gardener GmbH.

**16.** Pressure-sensitive adhesive according to at least one of the preceding claims,
**characterized in that**
said tackifier resin used is partially or fully hydrogenated resin based on rosin and rosin derivatives, hydrogenated polymer of dicyclopentadiene, partially, selectively or fully hydrogenated hydrocarbon resin based on $C_5$, $C_5/C_9$ or $C_9$ monomer streams, polyterpene resin based on $\alpha$-pinene and/or $\beta$-pinene and/or $\delta$-limonene, hydrogenated polymer of C8 and C9 aromatics, or a mixture thereof.

**17.** Pressure-sensitive adhesive according to Claim 16,
**characterized in that**
said partially or fully hydrogenated resin based on rosin and rosin derivatives used is glycerol ester of fully hydrogenated resin.

**18.** Use of a pressure-sensitive adhesive for encapsulating an (opto)electronic arrangement with respect to permeants,
**characterized in that**
the pressure-sensitive adhesive is a PSA according to at least one of the preceding claims.

**19.** Use according to Claim 18,
**characterized in that**
a single-sidedly or double-sidedly adhesive tape formed with the PSA is used for encapsulating the (opto)electronic arrangement with respect to permeants.

**20.** Use according to Claim 18 or 19,
**characterized in that**
the pressure-sensitive adhesive and/or the regions of the electronic arrangement that are to be encapsulated are heated before, during and/or after the application of the pressure-sensitive adhesive.

**21.** Use according to at least one of Claims 18 to 20,
**characterized in that**
the pressure-sensitive adhesive is cured partly or to completion on the electronic arrangement after application.

**22.** Electronic arrangement having an electronic structure and a pressure-sensitive adhesive,
the electronic structure being at least partly encapsulated by the pressure-sensitive adhesive,
**characterized**
**in that** the pressure-sensitive adhesive is designed according to at least one of the preceding claims.

**23.** Electronic arrangement according to Claim 22,
**characterized in that**
the electronic structure is an organic electronic structure.

**Revendications**

**1.** Matériau adhésif sensible à la pression pour l'encapsulation d'un système électronique contre des perméats, qui contient un mélange d'au moins un élastomère thermoplastique fluoré et d'au moins un élastomère liquide fluoré, **caractérisé en ce que** le matériau adhésif sensible à la pression contient en outre au moins une résine adhésive au moins partiellement hydrogénée.

**2.** Matériau adhésif sensible à la pression selon la revendication 1, **caractérisé en ce que** le matériau adhésif sensible à la pression contient au moins 70 % en poids, de préférence 90 % en poids (à chaque fois par rapport à la composition totale du matériau adhésif sensible à la pression) de ce mélange.

**3.** Matériau adhésif sensible à la pression selon la revendication 1 ou 2, **caractérisé en ce que** le rapport en masse entre l'élastomère liquide fluoré et l'élastomère thermoplastique fluoré est compris entre 5:95 et 55:45, de préférence entre 15:75 et 50:50, et de manière particulièrement préférée entre 25:75 et 40:60.

**4.** Matériau adhésif sensible à la pression selon l'une quelconque des revendications 1 à 3, **caractérisé en ce que** le ou les élastomères thermoplastiques fluorés comprennent un élastomère fluoré contenant (i) au moins un segment souple constitué par un terpolymère de fluorure de vinylidène/hexafluoropropylène/tétrafluoroéthylène ou de fluorure de vinylidène/chlorotrifluoroéthylène/tétrafluoroéthylène, et (ii) au moins un segment dur, constitué par (a) un copolymère de tétrafluoroéthylène/éthylène ou de chlorotrifluoroéthylène/éthylène ou (b) le polyfluorure de vinylidène.

**5.** Matériau adhésif sensible à la pression selon au moins l'une quelconque des revendications précédentes, **caractérisé en ce que** le ou les élastomères thermoplastiques fluorés comprennent un élastomère fluoré contenant (i) au moins un segment souple constitué par un copolymère de tétrafluoroéthylène/propylène et (ii) au moins un segment dur constitué par un copolymère de tétrafluoroéthylène/éthylène.

**6.** Matériau adhésif sensible à la pression selon au moins l'une quelconque des revendications précédentes, **caractérisé en ce que** le ou les élastomères thermoplastiques fluorés comprennent un élastomère fluoré contenant (i) au moins un segment souple en un copolymère caoutchoutique amorphe de tétrafluoroéthylène/éther de perfluoroalkylvinyle et (ii) au moins un segment dur d'un copolymère de tétrafluoroéthylène/éther de perfluoroalkylvinyle, la teneur en éther de perfluoroalkylvinyle étant inférieure à celle du segment souple.

**7.** Matériau adhésif sensible à la pression selon au moins l'une quelconque des revendications précédentes, **caractérisé en ce que** l'élastomère thermoplastique fluoré est compatible avec l'élastomère liquide fluoré.

**8.** Matériau adhésif sensible à la pression selon au moins l'une quelconque des revendications précédentes, **caractérisé en ce que** le matériau adhésif sensible à la pression contient la combinaison (i) d'un élastomère liquide fluoré de fluorure de vinylidène, hexafluoropropylène et tétrafluoroéthylène et (ii) d'un élastomère thermoplastique fluoré qui comprend un segment souple en le même terpolymère que l'élastomère liquide.

**9.** Matériau adhésif sensible à la pression selon au moins l'une quelconque des revendications 1 à 7, **caractérisé en ce que** le matériau adhésif sensible à la pression contient la combinaison (i) d'un élastomère liquide fluoré, qui est un copolymère de tétrafluoroéthylène/propylène ou un copolymère de tétrafluoroéthylène/éther de perfluoropropylvinyle, et (ii) d'un élastomère thermoplastique fluoré contenant un segment souple en le même copolymère que l'élastomère liquide.

10. Matériau adhésif sensible à la pression selon au moins l'une quelconque des revendications précédentes, **caractérisé en ce que** des élastomères à base de fluorure de vinylidène/hexafluoropropylène, de fluorure de vinylidène/hexafluoropropylène/tétrafluoroéthylène, de tétrafluoroéthylène/propylène, d'hexafluoropropylène/éthylène, des élastomères de fluorosilicone et/ou des élastomères de phosphazène à substitution fluor sont utilisés en tant qu'élastomères liquides fluorés.

11. Matériau adhésif sensible à la pression selon au moins l'une quelconque des revendications précédentes, **caractérisé en ce que** le matériau adhésif sensible à la pression est réticulé, de préférence par une réticulation aminée ou par une réticulation avec un bisphénol (tel que par exemple le bisphénol AF) ou par une réticulation avec des peroxydes.

12. Matériau adhésif sensible à la pression selon au moins l'une quelconque des revendications précédentes, **caractérisé en ce que** le matériau adhésif sensible à la pression contient un ou plusieurs additifs, de préférence choisis dans le groupe constitué par les agents plastifiants, les antioxydants primaires, les antioxydants secondaires, les stabilisateurs de procédé, les agents photoprotecteurs, les adjuvants d'usinage, les résines renforçantes à bloc terminal, les polymères, notamment de nature élastomère.

13. Matériau adhésif sensible à la pression selon au moins l'une quelconque des revendications précédentes, **caractérisé en ce que** le matériau adhésif sensible à la pression contient une ou plusieurs charges, de préférence des charges nanométriques, des charges transparentes et/ou des charges attractrices et/ou pièges.

14. Matériau adhésif sensible à la pression selon au moins l'une quelconque des revendications précédentes, **caractérisé en ce que** le matériau adhésif sensible à la pression est transparent dans la lumière visible du spectre (plage de longueur d'onde allant d'environ 400 nm à 800 nm) et présente une transmission supérieure à 75 % à une longueur d'onde de 400 nm à 800 nm.

15. Matériau adhésif sensible à la pression selon au moins l'une quelconque des revendications précédentes, **caractérisé en ce que** le matériau adhésif sensible à la pression présente un trouble inférieur à 5,0 %, de préférence inférieur à 2,5 %, selon ASTM D 1003, mesuré avec un Hazeguard Dual de Byk Gardener GmbH.

16. Matériau adhésif sensible à la pression selon au moins l'une quelconque des revendications précédentes, **caractérisé en ce qu'**une résine partiellement ou entièrement hydrogénée à base de colophane et de dérivés de colophane, un polymère hydrogéné de dicyclopentadiène, une résine hydrocarbonée partiellement, sélectivement ou entièrement hydrogénée à base de courants de monomères en $C_5$, $C_5/C_9$ ou $C_9$, une résine de polyterpène à base d'$\alpha$-pinène et/ou de $\beta$-pinène et/ou de $\delta$-limonène, un polymère hydrogéné de composés aromatiques en C8 et C9 ou un mélange de ceux-ci est utilisé en tant que résine adhésive.

17. Matériau adhésif sensible à la pression selon la revendication 16, **caractérisé en ce que** de l'ester de glycérine de colophane entièrement hydrogéné est utilisé en tant que résine partiellement ou entièrement hydrogénée à base de colophane et de dérivés de colophane.

18. Utilisation d'un matériau adhésif sensible à la pression pour l'encapsulation d'un système (opto-)électronique contre des perméats, **caractérisé en ce que** le matériau adhésif sensible à la pression est un matériau adhésif sensible à la pression selon au moins l'une quelconque des revendications précédentes.

19. Utilisation selon la revendication 18, **caractérisé en ce qu'**une bande adhésive mono ou double face formée avec le matériau adhésif sensible à la pression est utilisée pour l'encapsulation du système (opto-)électronique contre des perméats.

20. Utilisation selon la revendication 18 ou 19, **caractérisée en ce que** le matériau adhésif sensible à la pression et/ou les zones à encapsuler du système électronique sont chauffés avant, pendant et/ou après l'application du matériau adhésif sensible à la pression.

21. Utilisation selon au moins l'une quelconque des revendications 18 à 20, **caractérisée en ce que** le matériau adhésif sensible à la pression est partiellement ou post-réticulé après l'application sur le système électronique.

**22.** Système électronique comprenant une structure électronique et un matériau adhésif sensible à la pression, la structure électronique étant au moins partiellement encapsulée par le matériau adhésif sensible à la pression, **caractérisé en ce que** le matériau adhésif sensible à la pression est formé selon au moins l'une quelconque des revendications précédentes.

**23.** Système électronique selon la revendication 22, **caractérisé en ce que** la structure électronique est une structure électronique organique.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9821287 A1
- US 4051195 A
- US 4552604 A
- US 20040225025 A1
- DE 102008060113 A1
- EP 1518912 A1
- EP 0399543 A2
- US 4647157 A
- JP 53086786 A
- US 4158678 A
- JP 53003495 A
- JP 56057811 A
- US 4361678 A
- US 20070135552 A1
- WO 02026908 A1

**In der Beschreibung aufgeführte Nicht-Patentliteratur**

- **VON DONATAS SATAS.** Handbook of Pressure Sensitive Adhesive Technology. Satas & Associates, 1999
- **ALBER L. MOORE.** Fluoroelastomer Handbook: The Definite Users Guide and Databook. William Andrew Publishing/Plastics Design Library, 2005
- **VON A.G. ERLAT.** 47th Annual Technical Conference Proceedings-Society of Vacuum Coaters. 2004, 654-659
- **VON M. E. GROSS et al.** *46th Annual Technical Conference Proceedings-Society of Vacuum Coaters,* 2003, 89-92